# EUROPEAN PATENT APPLICATION

(11) **EP 4 450 509 A1**
(43) Date of publication of application: **23.10.2024**
(21) Application number: 23168888.8
(22) Date of filing: 20.04.2023
(51) Int. Cl.: C07F 7/08, H10K 50/11, H10K 85/60

(54) **COMPOUND, METHOD AND PRECURSOR COMPOUND FOR PREPARING THE COMPOUND, SEMICONDUCTING MATERIAL, ORGANIC ELECTRONIC DEVICE, AND DISPLAY DEVICE**

(71) Applicant: Novaled GmbH, 01099 Dresden (DE)
(72) Inventor: GALÁN GARCÍA, Elena, 01099 Dresden (DE); KARPOV, Yevhen, 01099 Dresden (DE); PAVICIC, Domagoj, 01099 Dresden (DE); MAI, Susanne, 01099 Dresden (DE)
(74) Representative: Bittner, Thomas L.

(57) **Abstract**

The present invention relates to a compound. The present invention relates further to a semiconducting material comprising the compound, to an organic electronic device comprising the semiconducting material, and to a display device comprising the organic electronic device.

## Description

### TECHNICAL FIELD

The present invention relates to a compound. The present invention relates further to a precursor compound and a method for preparing said compound. The present invention relates further to a semiconducting material comprising the compound, to an organic electronic device comprising the semiconducting material, to a display device comprising the organic electronic device, and to a process for preparing the organic electronic device.

### BACKGROUND OF THE INVENTION

Organic semiconducting devices, such as organic light-emitting diodes OLEDs, which are self-emitting devices, have a wide viewing angle, excellent contrast, quick response, high brightness, excellent operating voltage characteristics, and color reproduction. A typical OLED comprises an anode, a hole transport layer HTL, an emission layer EML, an electron transport layer ETL, and a cathode, which are sequentially stacked on a substrate. In this regard, the HTL, the EML, and the ETL are thin films formed from organic compounds.

When a voltage is applied to the anode and the cathode, holes injected from the anode move to the EML, via the HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency and/or a long lifetime.

Performance of an organic light emitting diode may be affected by characteristics of the organic semiconductor layer, and among them, may be affected by characteristics of an organic material of the organic semiconductor layer.

Particularly, development of an organic semiconductor layer being capable of increasing electron mobility and simultaneously increasing electrochemical stability is needed so that the organic semiconducting device, such as an organic light emitting diode, may be applied to a large-size flat panel display.

Further, development of an organic semiconductor layer being capable to have an extended life span at higher current density and thereby at higher brightness is needed. In particular, the development of an organic semiconductor material or semiconductor layer is needed with respect to lowering the operating voltage, which is important for reducing power consumption and increasing battery life, for example of a mobile display device.

It is, therefore, the object of the present invention to provide compounds and semiconducting materials for preparing organic electronic devices and display devices overcoming drawbacks of the prior art, in particular with improved performance, especially with at least one of lower operational voltage and higher current efficiency.

### DISCLOSURE

This object is achieved by a compound comprising
- a structural moiety of the following formula (I) 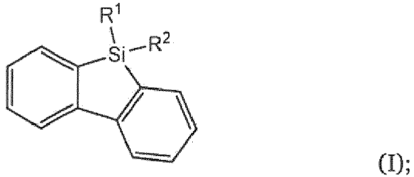 and
- a structural moiety of the following formula (II)

   A-(Cy)ₙ-B (II)

   wherein
- R¹ and R² are independently selected from the group consisting of substituted or unsubstituted C₁ to C₂₂ hydrocarbyl;
- A and B are independently selected from the group consisting of substituted or unsubstituted azine, substituted or unsubstituted diazine and substituted or unsubstituted triazine;
- Cy is a substituted or unsubstituted cyclic linker; and
- n is an integer from 1 to 3.

This object is further achieved by a semiconducting material comprising the compound according to the present invention.

This object is further achieved by an organic electronic device comprising a first electrode, a second electrode and a layer comprising the semiconducting material according to the present invention between the first electrode and the second electrode.

This object is further achieved by a display device comprising the organic electronic device according to the present invention.

This object is further achieved by a process for preparing the organic electronic device according to the invention, wherein the process comprises a step of depositing the compound according to the present invention on a solid support.

This object is further achieved by a process for preparing the compound comprising:
reacting a first precursor compound comprising a structural moiety (Ia) 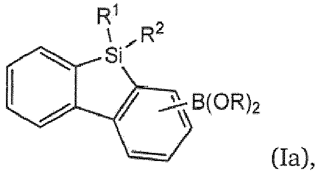 wherein
   - R¹ and R² are independently selected from the group consisting of substituted or unsubstituted C₁ to C₂₂ hydrocarbyl; and
   - R is independently H or a C₁ to C₂₂ hydrocarbyl, wherein the R may be connected with each other to form a ring,
with a second precursor compound having the formula (IIa)

   X-A-(Cy)ₙ-B (IIa)

   wherein
   - A and B are independently selected from the group consisting of substituted or unsubstituted azine, substituted or unsubstituted diazine and substituted or unsubstituted triazine;
   - Cy is a substituted or unsubstituted cyclic linker; and
   - n is an integer from 1 to 3.

The object is further achieved by precursor compound for preparing a compound according to the invention, the precursor compound having the following formula (IIb) 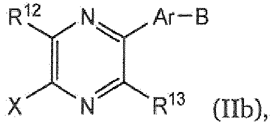 wherein
- R¹² and R¹³ are independently selected from an unsubstituted or substituted C₆ to C₁₈ aryl;
- Ar is selected from an unsubstituted or substituted C₆ to C₁₀ arylene,
- B is selected from the group consisting of substituted or unsubstituted azine, substituted or unsubstituted diazine and substituted or unsubstituted triazine; and
X is selected from F, Cl, Br and I.

Surprisingly, it was found that the compound according to the invention, respectively the semiconducting material comprising the same, can be used for preparing organic electronic devices and display devices having improved properties in comparison with respective devices of the prior art, especially with improved (lower) operational voltage and improved (higher) current efficiency.

### Compound

According to one aspect, the invention is related to a compound comprising
- a structural moiety of the following formula (I) 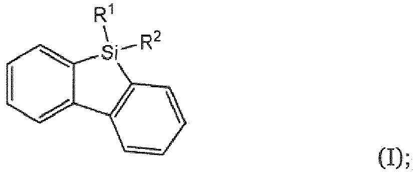 and
- a structural moiety of the following formula (II)

   A-(Cy)ₙ-B (II).

The structural moiety of the formula (I) may be directly linked, that is, connected via a single bond, to at least one of A and B.

The compound in accordance with the present invention may have the following formula (III) 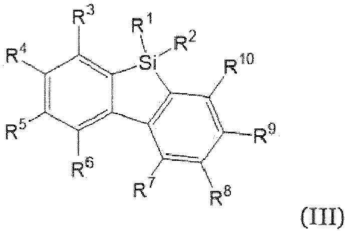 wherein
- R¹ and R² are independently selected from the group consisting of substituted or unsubstituted C₁ to C₂₂ hydrocarbyl;
- R³ to R¹⁰ are independently selected from the group consisting of a structural moiety of the formula (II) ((II) = A-(Cy)ₙ-B), H, D, C₆ to C₁₂ aryl, C₃ to C₁₁ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₆ alkyl, partially or perfluorinated C₁ to C₆ alkoxy, partially or perdeuterated C₁ to C₆ alkyl, partially or perdeuterated C₁ to C₆ alkoxy, halogen, CN or PY(R¹¹)₂, wherein Y is selected from O, S or Se, preferably O, and R₁₁ is independently selected from C₆ to C₁₂ aryl, C₃ to C₁₂ heteroaryl, C₁ to C₆ alkyl, C₁ to C₆ alkoxy, partially or perfluorinated C₁ to C₆ alkyl, partially or perfluorinated C₁ to C₆ alkoxy, partially or perdeuterated C₁ to C₆ alkyl, partially or perdeuterated C₁ to C₆ alkoxy, wherein each C₆ to C₁₂ aryl substituent and each C₃ to C₁₁ heteroaryl may be substituted with D, C₁ to C₄ alkyl or halogen;
- at least one of R³ to R¹⁰ is the structural moiety of the formula (II);
- A and B are independently selected from the group consisting of substituted or unsubstituted azine, substituted or unsubstituted diazine and substituted or unsubstituted triazine;
- Cy is a substituted or unsubstituted cyclic linker; and
- n is an integer from 1 to 3.

It may be provided that at least one of R³ to R¹⁰ is C₆ to C₁₂ aryl.

The compound in accordance with the present invention may have the following formula 1 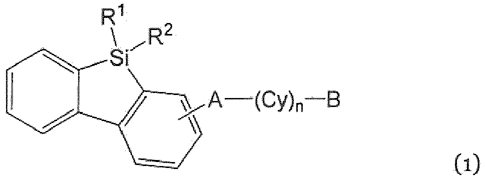 wherein
- R¹ and R² are independently selected from the group consisting of substituted or unsubstituted C₁ to C₂₂ hydrocarbyl;
- A and B are independently selected from the group consisting of substituted or unsubstituted azine, substituted or unsubstituted diazine and substituted or unsubstituted triazine;

Cy is a substituted or unsubstituted cyclic linker; and
n is an integer from 1 to 3.

In accordance with the present disclosure, in a formula showing the following binding situation for an arbitrary group G, 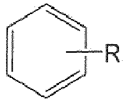 the arbitrary group R may be bound to any suitable binding position.

The compound in accordance with the present invention may have the following formula 2 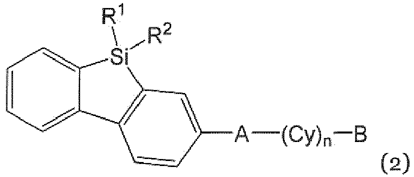 wherein
- R¹ and R² are independently selected from the group consisting of substituted or unsubstituted C₁ to C₂₂ hydrocarbyl;
- A and B are independently selected from the group consisting of substituted or unsubstituted azine, substituted or unsubstituted diazine and substituted or unsubstituted triazine;

Cy is a substituted or unsubstituted cyclic linker; and
n is an integer from 1 to 3.

If not mentioned else explicitly, all compounds, groups, moieties, substituents etc. shown herein, especially by structural formulas, by systematic names etc. encompass the respective partially and fully deuterated derivatives thereof.

R¹ and R² are independently selected from the group consisting of substituted or unsubstituted C₁ to C₂₂ hydrocarbyl. R¹ and R² may be linked with each other, especially may be linked with each other via a single bond, to form a ring.

In terms of the present disclosure, "hydrocarbyl" refers to univalent groups formed by removing a hydrogen atom from a hydrocarbon, e.g. ethyl, phenyl etc. "Hydrocarbylene" refers to respective di- or more-valent groups, such as ethylene, phenylene etc.

R¹ and R² may be independently selected from the group consisting of substituted or unsubstituted C₁ to C₂₀ hydrocarbyl. R¹ and R² may be independently selected from the group consisting of substituted or unsubstituted C₁ to C₁₈ hydrocarbyl. R¹ and R² may be independently selected from the group consisting of substituted or unsubstituted C₁ to C₁₆ hydrocarbyl. R¹ and R² may be independently selected from the group consisting of substituted or unsubstituted C₁ to C₁₄ hydrocarbyl. R¹ and R² may be independently selected from the group consisting of substituted or unsubstituted C₁ to C₁₂ hydrocarbyl. R¹ and R² may be independently selected from the group consisting of substituted or unsubstituted C₁ to C₁₀ hydrocarbyl. R¹ and R² may be independently selected from the group consisting of substituted or unsubstituted C₁ to C₈ hydrocarbyl. R¹ and R² may be independently selected from the group consisting of substituted or unsubstituted C₁ to C₆ hydrocarbyl. R¹ and R² may be independently selected from the group consisting of substituted or unsubstituted C₁ to C₄ hydrocarbyl. R¹ and R² may be independently selected from the group consisting of substituted or unsubstituted C₁ to C₂ hydrocarbyl. R¹ and R² may each C₁ hydrocarbyl (methyl).

R¹ and R² may be independently selected from the group consisting of substituted or unsubstituted C₁ to C₂₂ alkyl, substituted or unsubstituted C₃ to C₂₂ cycloalkyl; and substituted or unsubstituted C₆ to C₂₂ aryl. R¹ and R² may be independently selected from the group consisting of substituted or unsubstituted C₁ to C₁₈ alkyl, substituted or unsubstituted C₃ to C₁₈ cycloalkyl; and substituted or unsubstituted C₆ to C₁₈ aryl. R¹ and R² may be independently selected from the group consisting of substituted or unsubstituted C₁ to C₁₂ alkyl, substituted or unsubstituted C₃ to C₁₂ cycloalkyl; and substituted or unsubstituted C₆ to C₁₂ aryl. R¹ and R² may be independently selected from the group consisting of substituted or unsubstituted C₁ to C₆ alkyl, substituted or unsubstituted C₃ to C₇ cycloalkyl; and substituted or unsubstituted C₆ to C₁₀ aryl. R¹ and R² may be independently selected from the group consisting of substituted or unsubstituted C₁ to C₄ alkyl, substituted or unsubstituted C₅ to C₆ cycloalkyl; and substituted or unsubstituted C₆ to C₁₀ aryl. R¹ and R² may be independently selected from the group consisting of substituted or unsubstituted methyl, substituted or unsubstituted cyclohexyl and substituted or unsubstituted phenyl.

R¹ and R² may be independently selected from the group consisting of substituted or unsubstituted C₁ to C₂₂ alkyl. R¹ and R² may be independently selected from the group consisting of substituted or unsubstituted C₁ to C₂₀ alkyl. R¹ and R² may be independently selected from the group consisting of substituted or unsubstituted C₁ to C₁₈ alkyl. R¹ and R² may be independently selected from the group consisting of substituted or unsubstituted C₁ to C₁₆ alkyl. R¹ and R² may be independently selected from the group consisting of substituted or unsubstituted C₁ to C₁₄ alkyl. R¹ and R² may be independently selected from the group consisting of substituted or unsubstituted C₁ to C₁₂ alkyl. R¹ and R² may be independently selected from the group consisting of substituted or unsubstituted C₁ to C₁₀ alkyl. R¹ and R² may be independently selected from the group consisting of substituted or unsubstituted C₁ to C₈ alkyl. R¹ and R² may be independently selected from the group consisting of substituted or unsubstituted C₁ to C₆ alkyl. R¹ and R² may be independently selected from the group consisting of substituted or unsubstituted C₁ to C₄ alkyl. R¹ and R² may be independently selected from the group consisting of substituted or unsubstituted C₁ to C₂ alkyl. R¹ and R² may be each methyl.

If one or more of R₁ and R² is substituted, the one or more substituent(s) may be independently selected from the group consisting of D, C₆ to C₁₂ aryl, C₃ to C₁₁ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₆ alkyl, partially or perfluorinated C₁ to C₆ alkoxy, partially or perdeuterated C₁ to C₆ alkyl, partially or perdeuterated C₁ to C₆ alkoxy, halogen, CN or PY(R¹¹)₂, wherein Y is selected from O, S or Se, preferably O, and R¹¹ is independently selected from C₆ to C₁₂ aryl, C₃ to C₁₂ heteroaryl, C₁ to C₆ alkyl, C₁ to C₆ alkoxy, partially or perfluorinated C₁ to C₆ alkyl, partially or perfluorinated C₁ to C₆ alkoxy, partially or perdeuterated C₁ to C₆ alkyl, partially or perdeuterated C₁ to C₆ alkoxy,
- wherein each C₆ to C₁₂ aryl substituent and each C₃ to C₁₁ heteroaryl substituent on any of R¹ and R² may be substituted with D, C₁ to C₄ alkyl or halogen.

If one or more of R¹ and R² is substituted, the one or more substituent(s) may be independently selected from the group consisting of D, C₆ to C₁₂ aryl, C₃ to C₁₁ heteroaryl, C₁ to C₆ alkyl, partially or perfluorinated C₁ to C₆ alkyl, partially or perdeuterated C₁ to C₆ alkyl, halogen, CN or PO(R¹¹)₂, and R¹¹ is independently selected from C₆ to C₁₂ aryl, C₁ to C₆ alkyl, partially or perfluorinated C₁ to C₆ alkyl, partially or perdeuterated C₁ to C₆ alkyl,
- wherein each C₆ to C₁₂ aryl substituent and each C₃ to C₁₁ heteroaryl substituent on any of R¹ and R² may be substituted with D, C₁ to C₄ alkyl or halogen.

If one or more of R¹ and R² is substituted, the one or more substituent(s) may be independently selected from the group consisting of D, C₁ to C₆ alkyl, partially or perfluorinated C₁ to C₆ alkyl, partially or perdeuterated C₁ to C₆ alkyl.

If one or more of R¹ and R² is substituted, the one or more substituent(s) may be independently selected from the group consisting of D and C₁ to C₄ alkyl.

A and B are independently selected from the group consisting of substituted or unsubstituted azine, substituted or unsubstituted diazine and substituted or unsubstituted triazine. The respective azine, diazine or triazine is monocyclic, that is, does not contain a ring condensed to the azine, diazine or triazine.

The azine may have the following formula

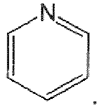

The diazine may have one of the following formulas

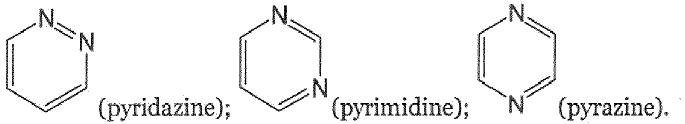

The triazine may have one of the following formulas

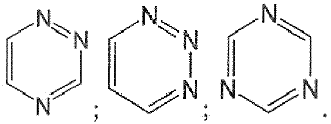

A and B may be independently selected from the group consisting of substituted or unsubstituted diazine and substituted or unsubstituted triazine. A and B may be independently selected from the group consisting of substituted or unsubstituted pyrimidine, substituted or unsubstituted pyrazine and substituted or unsubstituted triazine.

It may be provided that at least one of A and B is substituted or unsubstituted diazine. It may be provided that at least one of A and B is selected from the group consisting of substituted or unsubstituted pyrimidine and substituted or unsubstituted pyrazine.

It may be provided that one of A and B is substituted or unsubstituted diazine and the other of A and B is selected from the group consisting of substituted or unsubstituted pyrimidine, substituted or unsubstituted pyrazine and substituted or unsubstituted triazine. It may be provided that one of A and B is substituted or unsubstituted pyrimidine and substituted or unsubstituted pyrazine and the other of A and B is selected from the group consisting of substituted or unsubstituted pyrimidine, substituted or unsubstituted pyrazine and substituted or unsubstituted triazine.

It may be provided that A is substituted or unsubstituted pyrimidine or substituted or unsubstituted pyrazine and B is selected from the group consisting of substituted or unsubstituted pyrimidine, substituted or unsubstituted pyrazine and substituted or unsubstituted triazine. It may be provided that A is substituted or unsubstituted pyrazine and B is selected from the group consisting of substituted or unsubstituted pyrimidine, and substituted or unsubstituted triazine. It may be provided that A is substituted pyrazine and B is selected from the group consisting of substituted pyrimidine, and substituted triazine.

It may be provided that A is substituted pyrazine having the following formula 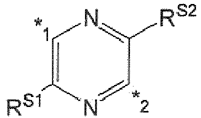 wherein R^{S1} and R^{S2} are the substituents; ^{∗}1 is the binding position to the remaining structure of the compound in accordance with the invention; and ^{∗}2 is the binding position to Cy in the formula (II).

It may be provided that B has one of the following formulas 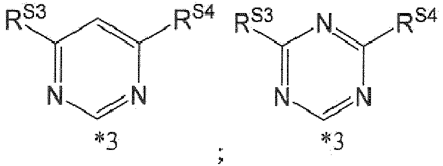 wherein R^{S3} and R^{s4} are the substituents; and ^{∗}3 is the binding position to Cy in the formula (II), respectively.

At least one of A and B may substituted pyrazine, wherein the one or more substituent(s) are independently selected from the group consisting of a hydrocarbyl group, a carbocyclic group, and a heterocyclic group.

If one or more of A and B is substituted, the one or more substituent(s) may be independently selected from the group consisting of D, C₁ to C₂₂ hydrocarbyl, especially C₃ to C₂₂ carbocyclyl, C₃ to C₂₂ heterocyclyl, C₁ to C₆ alkoxy, C₃ to C₆ branched alkoxy, C₃ to C₆ cyclic alkoxy, partially or perdeuterated C₁ to C₆ alkoxy, halogen, CN or PY(R¹¹)₂, wherein Y is selected from O, S or Se, preferably O, and R¹¹ is independently selected from C₆ to C₁₂ aryl, C₃ to C₁₂ heteroaryl, C₁ to C₆ alkyl, C₁ to C₆ alkoxy, partially or perfluorinated C₁ to C₆ alkyl, partially or perfluorinated C₁ to C₆ alkoxy, partially or perdeuterated C₁ to C₆ alkyl, partially or perdeuterated C₁ to C₆ alkoxy,
- wherein each C₁ to C₂₂ hydrocarbyl substituent and each C₃ to C₂₂ heterocyclyl substituent on any of A and B may be substituted with D, C₁ to C₄ alkyl or halogen.

If one or more of A and B is substituted, the one or more substituent(s) may be independently selected from the group consisting of D, C₆ to C₁₈ aryl, C₃ to C₁₇ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₆ alkyl, partially or perfluorinated C₁ to C₆ alkoxy, partially or perdeuterated C₁ to C₆ alkyl, partially or perdeuterated C₁ to C₆ alkoxy, halogen, CN or PY(R¹¹)2, wherein Y is selected from O, S or Se, preferably O, and R¹¹ is independently selected from C₆ to C₁₂ aryl, C₃ to C₁₂ heteroaryl, C₁ to C₆ alkyl, C₁ to C₆ alkoxy, partially or perfluorinated C₁ to C₆ alkyl, partially or perfluorinated C₁ to C₆ alkoxy, partially or perdeuterated C₁ to C₆ alkyl, partially or perdeuterated C₁ to C₆ alkoxy,
- wherein each C₆ to C₁₈ aryl substituent and each C₃ to C₁₇ heteroaryl substituent on any of A and B may be substituted with D, C₁ to C₄ alkyl or halogen.

If one or more of A and B is substituted, the one or more substituent(s) may be independently selected from the group consisting of D, C₆ to C₁₂ aryl, C₃ to C₁₁ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₆ alkyl, partially or perfluorinated C₁ to C₆ alkoxy, partially or perdeuterated C₁ to C₆ alkyl, partially or perdeuterated C₁ to C₆ alkoxy, halogen, CN or PY(R¹¹)₂, wherein Y is selected from O, S or Se, preferably O, and R¹¹ is independently selected from C₆ to C₁₂ aryl, C₃ to C₁₂ heteroaryl, C₁ to C₆ alkyl, C₁ to C₆ alkoxy, partially or perfluorinated C₁ to C₆ alkyl, partially or perfluorinated C₁ to C₆ alkoxy, partially or perdeuterated C₁ to C₆ alkyl, partially or perdeuterated C₁ to C₆ alkoxy,
- wherein each C₆ to C₁₂ aryl substituent and each C₃ to C₁₁ heteroaryl substituent on any of A and B may be substituted with D, C₁ to C₄ alkyl or halogen.

If one or more of A and B is substituted, the one or more substituent(s) may be monocyclic or bicyclic, that is, may comprise one or two rings.

If one or more of A and B is substituted, the one or more substituent(s) may be independently selected from the group consisting of C₆ to C₁₈ aryl and C₃ to C₁₇ heteroaryl,
- wherein each C₆ to C₁₈ aryl substituent and each C₃ to C₁₇ heteroaryl substituent on any of A and B may be substituted with D, C₁ to C₄ alkyl or halogen.

If one or more of A and B is substituted, the one or more substituent(s) may be independently selected from the group consisting of C₆ to C₁₂ aryl and C₃ to C₁₁ heteroaryl,
- wherein each C₆ to C₁₂ aryl substituent and each C₃ to C₁₁ heteroaryl substituent on any of A and B may be substituted with D, C₁ to C₄ alkyl or halogen.

If one or more of A and B is substituted, the one or more substituent(s) may be independently selected from the group consisting of C₆ to C₁₈ aryl,
- wherein each C₆ to C₁₈ aryl substituent on any of A and B may be substituted with D, C₁ to C₄ alkyl or halogen.

If one or more of A and B is substituted, the one or more substituent(s) may be independently selected from the group consisting of C₆ to C₁₂ aryl,
- wherein each C₆ to C₁₂ aryl substituent on any of A and B may be substituted with D, C₁ to C₄ alkyl or halogen.

If one or more of A and B is substituted, the one or more substituent(s) may be independently selected from the group consisting of naphtyl, biphenyl-yl, fluorenyl, 9,9'-dimethylfluorenyl, anthryl, pyrenyl, and triphenylen-yl, wherein each substituent on any of A and B may be substituted with D, C₁ to C₄ alkyl or halogen.

If one or more of A and B is substituted, the one or more substituent(s) may be each phenyl, wherein the phenyl substituent on any of A and B may be substituted with D, C₁ to C₄ alkyl or halogen.

A and B may be fully substituted, that is, may be substituted at any position not occupied by a bond shown in formula (II) or a bond to the remaining structure of the compound according to the invention, with C₆ to C₁₂ aryl. A and B may be fully substituted with phenyl.

Cy is a substituted or unsubstituted cyclic linker. "Cyclic" means in this regard that the respective group (linker) comprises at least one aromatic or aliphatic ring, especially may consist only of one or more aromatic or aliphatic rings, wherein if two or more rings are comprised, the rings may be annelated or not-annelated, may be connected with each other vie a single bond or may be connected via an aliphatic, olefinic etc. moiety. The term "linker" refers in this regard to a divalent cyclic group.

Cy may be independently monocyclic or bicyclic.

Cy may be independently selected from the group consisting of substituted or unsubstituted C₆ to C₁₈ arylene and substituted or unsubstituted C₃ to C₁₇ heteroarylene. Cy may be independently selected from the group consisting of substituted or unsubstituted C₆ to C₁₂ arylene and substituted or unsubstituted C₃ to C₁₁ heteroarylene. Cy may be independently selected from the group consisting of substituted or unsubstituted C₆ to C₁₂ arylene and substituted or unsubstituted C₄ to C₁₁ heteroarylene. Cy may be independently selected from the group consisting of substituted or unsubstituted C₆ to C₁₂ arylene and substituted or unsubstituted C₅ to C₁₁ heteroarylene. Cy may be independently selected from the group consisting of substituted or unsubstituted C₆ to C₁₀ arylene and substituted or unsubstituted C₅ to C₉ heteroarylene.

Cy may be independently selected from the group consisting of substituted or unsubstituted C₆ to C₁₈ arylene. Cy may be independently selected from the group consisting of substituted or unsubstituted C₆ to C₁₂ arylene. Cy may be independently selected from the group consisting of substituted or unsubstituted C₆ to C₁₀ arylene. Cy may be independently selected from the group consisting of substituted or unsubstituted phenylene or substituted or unsubstituted naphthalene-diylene. Cy may be substituted or unsubstituted phenylene. Cy may be independently selected from the group consisting of ortho-phenylene and meta-phenylene.

If one or more of Cy is substituted, the one or more substituent(s) may be independently selected from the group consisting of D, C₆ to C₁₂ aryl, C₃ to C₁₁ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₆ alkyl, partially or perfluorinated C₁ to C₆ alkoxy, partially or perdeuterated C₁ to C₆ alkyl, partially or perdeuterated C₁ to C₆ alkoxy, halogen, CN or PY(R¹¹)₂, wherein Y is selected from O, S or Se, preferably O, and R¹¹ is independently selected from C₆ to C₁₂ aryl, C₃ to C₁₂ heteroaryl, C₁ to C₆ alkyl, C₁ to C₆ alkoxy, partially or perfluorinated C₁ to C₆ alkyl, partially or perfluorinated C₁ to C₆ alkoxy, partially or perdeuterated C₁ to C₆ alkyl, partially or perdeuterated C₁ to C₆ alkoxy,
- wherein each C₆ to C₁₂ aryl substituent and each C₃ to C₁₁ heteroaryl substituent on any of Cy may be substituted with D, C₁ to C₄ alkyl or halogen.

If one or more of Cy is substituted, the one or more substituent(s) may be independently selected from the group consisting of D, C₆ to C₁₂ aryl, C₃ to C₁₁ heteroaryl, C₁ to C₆ alkyl, partially or perfluorinated C₁ to C₆ alkyl, partially or perdeuterated C₁ to C₆ alkyl, halogen, CN or PO(R¹¹)₂, and R¹¹ is independently selected from C₆ to C₁₂ aryl, C₁ to C₆ alkyl, partially or perfluorinated C₁ to C₆ alkyl, partially or perdeuterated C₁ to C₆ alkyl,
- wherein each C₆ to C₁₂ aryl substituent and each C₃ to C₁₁ heteroaryl substituent on any of Cy may be substituted with D, C₁ to C₄ alkyl or halogen.

If one or more of Cy is substituted, the one or more substituent(s) may be independently selected from the group consisting of D, C₁ to C₆ alkyl, partially or perfluorinated C₁ to C₆ alkyl, partially or perdeuterated C₁ to C₆ alkyl.

If one or more of Cy is substituted, the one or more substituent(s) may be independently selected from the group consisting of D and C₁ to C₄ alkyl.

n is from 1 to 3. n may be 1.

R³ to R¹⁰ may be independently selected from the group consisting of a structural moiety of the following formula (II) A-(Cy)ₙ-B (II), H, D, C₆ to C₁₂ aryl, C₃ to C₁₁ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₆ alkyl, partially or perfluorinated C₁ to C₆ alkoxy, partially or perdeuterated C₁ to C₆ alkyl, partially or perdeuterated C₁ to C₆ alkoxy, halogen, CN or PY(R¹¹)₂, wherein Y is selected from O, S or Se, preferably O, and R¹¹ is independently selected from C₆ to C₁₂ aryl, C₃ to C₁₂ heteroaryl, C₁ to C₆ alkyl, C₁ to C₆ alkoxy, partially or perfluorinated C₁ to C₆ alkyl, partially or perfluorinated C₁ to C₆ alkoxy, partially or perdeuterated C₁ to C₆ alkyl, partially or perdeuterated C₁ to C₆ alkoxy, wherein each C₆ to C₁₂ aryl substituent and each C₃ to C₁₁ heteroaryl may be substituted with D, C₁ to C₄ alkyl or halogen; wherein at least one of R³ to R¹⁰ is the structural moiety of the formula (II).

R³ to R¹⁰ may be independently selected from the group consisting of a structural moiety of the following formula (II) A-(Cy)ₙ-B (II), H, D, C₆ to C₁₂ aryl, C₃ to C₁₁ heteroaryl, C₁ to C₆ alkyl, partially or perfluorinated C₁ to C₆ alkyl, partially or perdeuterated C₁ to C₆ alkyl, halogen, CN or PO(R¹¹)₂, and R¹¹ is independently selected from C₆ to C₁₂ aryl, C₁ to C₆ alkyl, partially or perfluorinated C₁ to C₆ alkyl, partially or perdeuterated C₁ to C₆ alkyl, wherein each C₆ to C₁₂ aryl substituent and each C₃ to C₁₁ heteroaryl may be substituted with D, C₁ to C₄ alkyl or halogen; wherein at least one of R³ to R¹⁰ is the structural moiety of the formula (II).

R³ to R¹⁰ may be independently selected from the group consisting of a structural moiety of the following formula (II) A-(Cy)ₙ-B (II), H, D, C₁ to C₆ alkyl, partially or perfluorinated C₁ to C₆ alkyl, partially or perdeuterated C₁ to C₆ alkyl, wherein at least one of R³ to R¹⁰ is the structural moiety of the formula (II).

In one embodiment, the compound in accordance with the present invention has the formula (III) 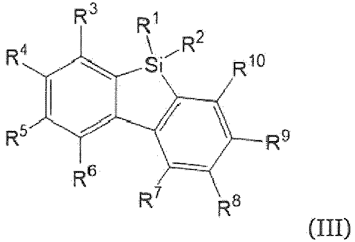 wherein
- R¹ and R² are independently selected from the group consisting of substituted or unsubstituted C₁ to C₂₂ alkyl, substituted or unsubstituted C₃ to C₂₂ cycloalkyl; and substituted or unsubstituted C₆ to C₂₂ aryl;
- if one or more of R¹ and R² is substituted, the one or more substituent(s) may be independently selected from the group consisting of D, C₆ to C₁₂ aryl, C₃ to C₁₁ heteroaryl, C₁ to C₆ alkyl, partially or perfluorinated C₁ to C₆ alkyl, partially or perdeuterated C₁ to C₆ alkyl, halogen, CN or PO(R¹¹)₂, and R¹¹ is independently selected from C₆ to C₁₂ aryl, C₁ to C₆ alkyl, partially or perfluorinated C₁ to C₆ alkyl, partially or perdeuterated C₁ to C₆ alkyl, wherein each C₆ to C₁₂ aryl substituent and each C₃ to C₁₁ heteroaryl substituent on any of R¹ and R² may be substituted with D, C₁ to C₄ alkyl or halogen;
- R³ to R¹⁰ are independently selected from the group consisting of a structural moiety of the following formula (II) A-(Cy)ₙ-B (II), H, D, C₆ to C₁₂ aryl, C₃ to C₁₁ heteroaryl, C₁ to C₆ alkyl, partially or perfluorinated C₁ to C₆ alkyl, partially or perdeuterated C₁ to C₆ alkyl, halogen, CN or PO(R¹¹)₂, and R¹¹ is independently selected from C₆ to C₁₂ aryl, C₁ to C₆ alkyl, partially or perfluorinated C₁ to C₆ alkyl, partially or perdeuterated C₁ to C₆ alkyl, wherein each C₆ to C₁₂ aryl and each C₃ to C₁₁ heteroaryl may be substituted with D, C₁ to C₄ alkyl or halogen;
- wherein at least one of R³ to R¹⁰ is the structural moiety of the formula (II);
- A and B are independently selected from the group consisting of substituted or unsubstituted diazine and substituted or unsubstituted triazine;
- if one or more of A and B is substituted, the one or more substituent(s) may be independently selected from the group consisting of C₆ to C₁₂ aryl and C₃ to C₁₁ heteroaryl, wherein each C₆ to C₁₂ aryl substituent and each C₃ to C₁₁ heteroaryl substituent on any of A and B may be substituted with D, C₁ to C₄ alkyl or halogen;
- Cy is independently selected from the group consisting of substituted or unsubstituted cyclic C₆ to C₁₈ arylene and substituted or unsubstituted C₃ to C₁₇ heteroarylene;
- if one or more of Cy is substituted, the one or more substituent(s) may be independently selected from the group consisting of D, C₆ to C₁₂ aryl, C₃ to C₁₁ heteroaryl, C₁ to C₆ alkyl, partially or perfluorinated C₁ to C₆ alkyl, partially or perdeuterated C₁ to C₆ alkyl, halogen, CN or PO(R¹¹)₂, and R¹¹ is independently selected from C₆ to C₁₂ aryl, C₁ to C₆ alkyl, partially or perfluorinated C₁ to C₆ alkyl, partially or perdeuterated C₁ to C₆ alkyl, wherein each C₆ to C₁₂ aryl substituent and each C₃ to C₁₁ heteroaryl substituent on Cy may be substituted with D, C₁ to C₄ alkyl or halogen; and
- n is 1.

In one embodiment, the compound in accordance with the present invention has the following formula 1 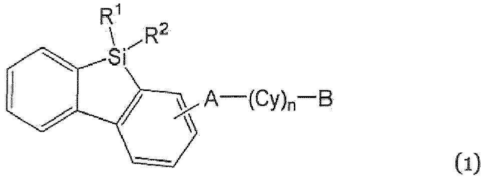 wherein
- R¹ and R² are independently selected from the group consisting of substituted or unsubstituted C₁ to C₂₂ alkyl;
- if one or more of R¹ and R² is substituted, the one or more substituent(s) may be D;
- one of A and B is substituted or unsubstituted diazine and the other of A and B is selected from the group consisting of substituted or unsubstituted pyrimidine, substituted or unsubstituted pyrazine and substituted or unsubstituted triazine;
- if one or more of A and B is substituted, the one or more substituent(s) may be independently selected from the group consisting of C₆ to C₁₂ aryl and C₃ to C₁₁ heteroaryl, wherein each C₆ to C₁₂ aryl substituent and each C₃ to C₁₁ heteroaryl substituent on any of A and B may be substituted with D, C₁ to C₄ alkyl or halogen;
- Cy is independently selected from the group consisting of substituted or unsubstituted cyclic C₆ to C₁₈ arylene;
- if one or more of Cy is substituted, the one or more substituent(s) may be independently selected from the group consisting of D, C₁ to C₆ alkyl, partially or perfluorinated C₁ to C₆ alkyl, partially or perdeuterated C₁ to C₆ alkyl; and
- n is 1.

In one embodiment, the compound in accordance with the present invention may have the following formula 2 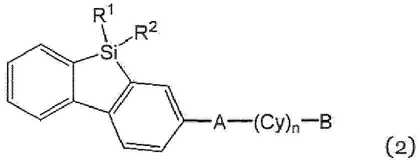 wherein
- R¹ and R² are independently selected from the group consisting of substituted or unsubstituted C₁ to C₆ alkyl;
- if one or more of R¹ and R² is substituted, the one or more substituent(s) may be D;
- A is substituted pyrazine and B is selected from the group consisting of substituted pyrimidine, and substituted triazine;
- the substituent(s) on A and B are independently selected from the group consisting of C₆ to C₁₂ aryl, wherein each C₆ to C₁₂ aryl substituent on any of A and B may be substituted with one or more D and/or one or more C₁ to C₄ alkyl;
- Cy is independently selected from the group consisting of substituted or unsubstituted cyclic C₆ to C₁₀ arylene;
- if Cy is substituted, the one or more substituent(s) may be independently selected from the group consisting of D, and C₁ to C₄ alkyl; and
- n is 1.

The compound according to the present invention may be one of E1 to E4

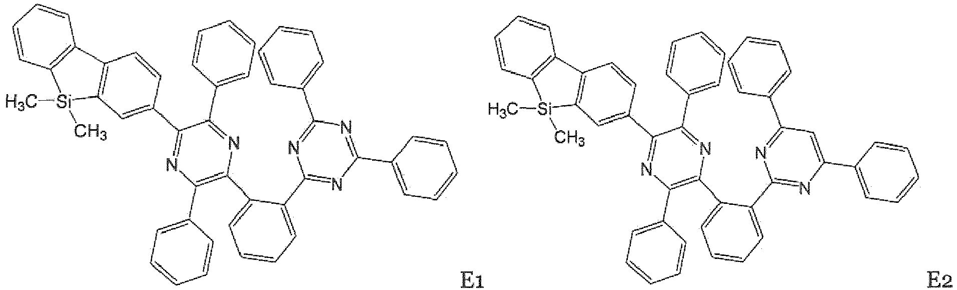

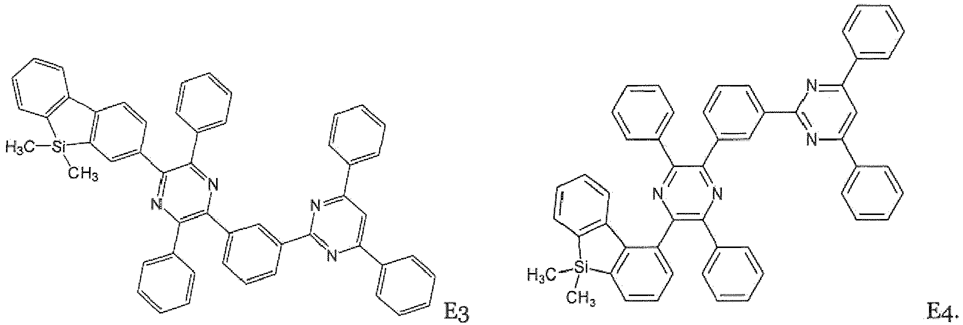

### Process for preparation of the compound according to the present invention

According to one aspect, the invention is related to a process for preparing the compound according to the invention, the process comprising:
reacting a first precursor compound comprising a structural moiety (Ia) 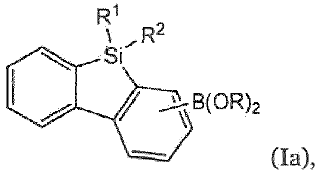 wherein
   - R¹ and R² are independently selected from the group consisting of substituted or unsubstituted C₁ to C₂₂ hydrocarbyl; and
   - R is independently H or a C₁ to C₂₂ hydrocarbyl,
with a second precursor compound having the formula (IIa)

   X-A-(Cy)n-B (IIa)

   wherein
   - A and B are independently selected from the group consisting of substituted or unsubstituted azine, substituted or unsubstituted diazine and substituted or unsubstituted triazine;
   - Cy is a substituted or unsubstituted cyclic linker; and
   - n is an integer from 1 to 3.

R¹, R², A, Cy, B, and n in the first and the second precursor compound may be selected as described above with respect to the compound according to the invention.

R is independently H or a C₁ to C₂₂ hydrocarbyl, wherein the R may be connected with each other to form a ring. R may independently H or a C₁ to C₂₀ hydrocarbyl, wherein the R may be connected with each other to form a ring. R may independently H or a C₁ to C₁₈ hydrocarbyl, wherein the R may be connected with each other to form a ring. R may independently H or a C₁ to C₁₆ hydrocarbyl, wherein the R may be connected with each other to form a ring. R may independently H or a C₁ to C₁₄ hydrocarbyl, wherein the R may be connected with each other to form a ring. R may independently H or a C₁ to C₁₂ hydrocarbyl, wherein the R may be connected with each other to form a ring. R may independently H or a C₁ to C₁₀ hydrocarbyl, wherein the R may be connected with each other to form a ring. R may independently H or a C₁ to C₈ hydrocarbyl, wherein the R may be connected with each other to form a ring. R may independently H or a C₁ to C₆ hydrocarbyl, wherein the R may be connected with each other to form a ring. R may independently H or a C₁ to C₄ hydrocarbyl, wherein the R may be connected with each other to form a ring. R may independently H or a C₁ to C₃ hydrocarbyl, wherein the R may be connected with each other to form a ring.

R may be independently C₁ to C₂₂ alkyl, wherein the R may be connected with each other to form a ring. R may independently C₁ to C₂₀ alkyl, wherein the R may be connected with each other to form a ring. R may independently C₁ to C₁₈ alkyl, wherein the R may be connected with each other to form a ring. R may independently C₁ to C₁₆ alkyl, wherein the R may be connected with each other to form a ring. R may independently C₁ to C₁₄ alkyl, wherein the R may be connected with each other to form a ring. R may independently C₁ to C₁₂ alkyl, wherein the R may be connected with each other to form a ring. R may independently C₁ to C₁₀ alkyl, wherein the R may be connected with each other to form a ring. R may independently C₁ to C₈ alkyl, wherein the R may be connected with each other to form a ring. R may independently C₁ to C₆ alkyl, wherein the R may be connected with each other to form a ring. R may independently C₁ to C₄ alkyl, wherein the R may be connected with each other to form a ring. R may independently C₁ to C₃ alkyl, wherein the R may be connected with each other to form a ring.

In case that the R are connected with each other, it is provided that the two R are connected with each other via a single bond.

The group B(OR)₂ may have the following formula 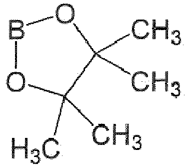 which is a case in which both R are C₃ alkyl which are connected with each other to form a ring.

X is a halogen atom selected from the group consisting of F, Cl, Br, and I. X may be Cl or Br. X may be Cl.

The second precursor may be selected from I1 to I3

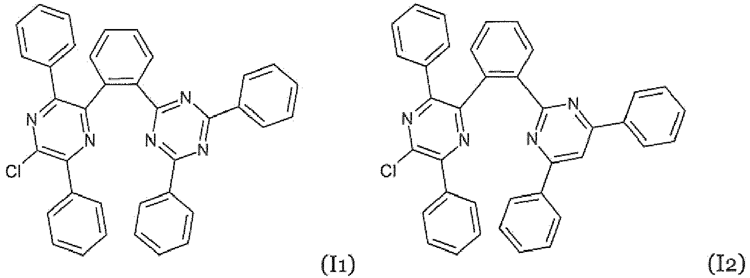

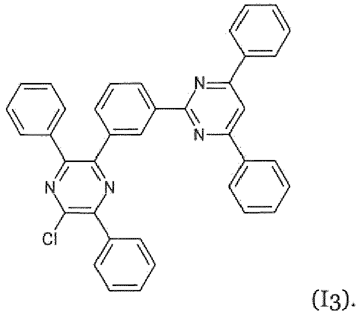

Reacting of the first precursor compound and the second precursor compound may take place in the presence of a catalyst. The catalyst may be a Suzuki-catalyst. The catalyst may be a Pd-containing catalyst. The catalyst may have the formula Pd(PPh₃)Cl₂. Alternatively, the catalyst may be Pd-172.

Reacting of the first precursor compound and the second precursor compound may take place in the presence of a base. Reacting of the first precursor compound and the second precursor compound may take place in the presence of a weak base. The weak base may be K₂CO₃ or K₃PO₄.

Reacting of the first precursor compound and the second precursor compound may take place in the presence of a solvent. Reacting of the first precursor compound and the second precursor compound may take place in the presence of a polar solvent. Reacting of the first precursor compound and the second precursor compound may take place in the presence of a mixture of an ether and water. Reacting of the first precursor compound and the second precursor compound may take place in the presence of a mixture of an cyclic ether and water. Reacting of the first precursor compound and the second precursor compound may take place in the presence of a mixture of THF and water or a mixture of dioxane and water.

Reacting of the first precursor compound and the second precursor compound may take place at a temperature from 50 to 100 °C. Reacting of the first precursor compound and the second precursor compound may take place at a temperature from 60 to 90 °C. Reacting of the first precursor compound and the second precursor compound may take place at a temperature from 75 to 80 °C.

### Precursor compound

According to one aspect, the invention is related to a precursor compound having the formula (IIb)

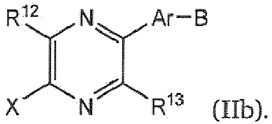

R¹² and R¹³ are independently selected from an unsubstituted or substituted C₆ to C₁₈ aryl. R¹² and R¹³ may be independently selected from the group consisting of phenyl, naphtyl, biphenyl-yl, fluorenyl, 9,9'-dimethylfluorenyl, anthryl, pyrenyl, triphenylene-yl. R¹² and R¹³ may be each phenyl.

Ar is selected from an unsubstituted or substituted C₆ to C₁₀ arylene. Ar may be selected from the group consisting of phenylene, and naphtalene-diyl. Ar may be phenylene. Ar may be ortho-phenylene, meta-phenylene or para-phenylene. Ar may be ortho-phenylene, or meta-phenylene.

B is selected from the group consisting of substituted or unsubstituted azine, substituted or unsubstituted diazine and substituted or unsubstituted triazine. The respective azine, diazine or triazine is monocyclic, that is, does not contain a ring condensed to the azine, diazine or triazine.

The azine may have the following formula

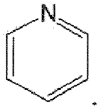

The diazine may have one of the following formulas

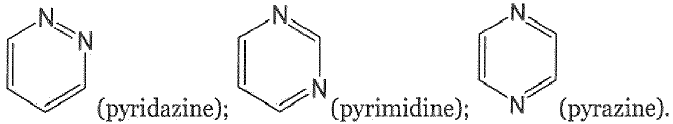

The triazine may have one of the following formulas

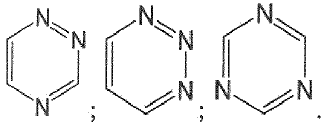

B may be independently selected from the group consisting of substituted or unsubstituted diazine and substituted or unsubstituted triazine. B may be independently selected from the group consisting of substituted or unsubstituted pyrimidine, substituted or unsubstituted pyrazine and substituted or unsubstituted triazine.

It may be provided that B has one of the following formulas 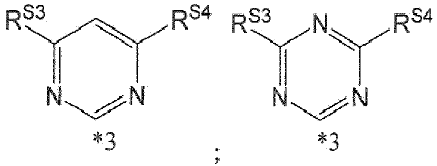 wherein R^{S3} and R^{s4} are the substituents; and ^{∗}3 is the binding position to Ar in the formula (IIb), respectively.

B may substituted pyrazine, wherein the one or more substituent(s) are independently selected from the group consisting of a hydrocarbyl group, a carbocyclic group, and a heterocyclic group.

If B is substituted, the one or more substituent(s) may be independently selected from the group consisting of D, C₁ to C₂₂ hydrocarbyl, especially C₃ to C₂₂ carbocyclyl, C₃ to C₂₂ heterocyclyl, C₁ to C₆ alkoxy, C₃ to C₆ branched alkoxy, C₃ to C₆ cyclic alkoxy, partially or perdeuterated C₁ to C₆ alkoxy, halogen, CN or PY(R¹¹)₂, wherein Y is selected from O, S or Se, preferably O, and R¹¹ is independently selected from C₆ to C₁₂ aryl, C₃ to C₁₂ heteroaryl, C₁ to C₆ alkyl, C₁ to C₆ alkoxy, partially or perfluorinated C₁ to C₆ alkyl, partially or perfluorinated C₁ to C₆ alkoxy, partially or perdeuterated C₁ to C₆ alkyl, partially or perdeuterated C₁ to C₆ alkoxy,
- wherein each C₁ to C₂₂ hydrocarbyl substituent and each C₃ to C₂₂ heterocyclyl substituent on B may be substituted with D, C₁ to C₄ alkyl or halogen.

If B is substituted, the one or more substituent(s) may be independently selected from the group consisting of D, C₆ to C₁₈ aryl, C₃ to C₁₇ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₆ alkyl, partially or perfluorinated C₁ to C₆ alkoxy, partially or perdeuterated C₁ to C₆ alkyl, partially or perdeuterated C₁ to C₆ alkoxy, halogen, CN or PY(R¹¹)₂, wherein Y is selected from O, S or Se, preferably O, and R₁₁ is independently selected from C₆ to C₁₂ aryl, C₃ to C₁₂ heteroaryl, C₁ to C₆ alkyl, C₁ to C₆ alkoxy, partially or perfluorinated C₁ to C₆ alkyl, partially or perfluorinated C₁ to C₆ alkoxy, partially or perdeuterated C₁ to C₆ alkyl, partially or perdeuterated C₁ to C₆ alkoxy,
- wherein each C₆ to C₁₈ aryl substituent and each C₃ to C₁₇ heteroaryl substituent on B may be substituted with D, C₁ to C₄ alkyl or halogen.

If B is substituted, the one or more substituent(s) may be independently selected from the group consisting of D, C₆ to C₁₂ aryl, C₃ to C₁₁ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₆ alkyl, partially or perfluorinated C₁ to C₆ alkoxy, partially or perdeuterated C₁ to C₆ alkyl, partially or perdeuterated C₁ to C₆ alkoxy, halogen, CN or PY(R¹¹)₂, wherein Y is selected from O, S or Se, preferably O, and R¹¹ is independently selected from C₆ to C₁₂ aryl, C₃ to C₁₂ heteroaryl, C₁ to C₆ alkyl, C₁ to C₆ alkoxy, partially or perfluorinated C₁ to C₆ alkyl, partially or perfluorinated C₁ to C₆ alkoxy, partially or perdeuterated C₁ to C₆ alkyl, partially or perdeuterated C₁ to C₆ alkoxy,
- wherein each C₆ to C₁₂ aryl substituent and each C₃ to C₁₁ heteroaryl substituent on B may be substituted with D, C₁ to C₄ alkyl or halogen.

If B is substituted, the one or more substituent(s) may be monocyclic or bicyclic, that is, may comprise one or two rings.

If B is substituted, the one or more substituent(s) may be independently selected from the group consisting of C₆ to C₁₈ aryl and C₃ to C₁₇ heteroaryl,
- wherein each C₆ to C₁₈ aryl substituent and each C₃ to C₁₇ heteroaryl substituent on B may be substituted with D, C₁ to C₄ alkyl or halogen.

If B is substituted, the one or more substituent(s) may be independently selected from the group consisting of C₆ to C₁₂ aryl and C₃ to C₁₁ heteroaryl,
- wherein each C₆ to C₁₂ aryl substituent and each C₃ to C₁₁ heteroaryl substituent on B may be substituted with D, C₁ to C₄ alkyl or halogen.

If B is substituted, the one or more substituent(s) may be independently selected from the group consisting of C₆ to C₁₈ aryl,
- wherein each C₆ to C₁₈ aryl substituent on B may be substituted with D, C₁ to C₄ alkyl or halogen.

If B is substituted, the one or more substituent(s) may be independently selected from the group consisting of C₆ to C₁₂ aryl,
- wherein each C₆ to C₁₂ aryl substituent on B may be substituted with D, C₁ to C₄ alkyl or halogen.

If B is substituted, the one or more substituent(s) may be independently selected from the group consisting of naphtyl, biphenyl-yl, fluorenyl, 9,9'-dimethylfluorenyl, anthryl, pyrenyl, and triphenylen-yl, wherein each substituent on B may be substituted with D, C₁ to C₄ alkyl or halogen.

If B is substituted, the one or more substituent(s) may be each phenyl, wherein the phenyl substituent on B may be substituted with D, C₁ to C₄ alkyl or halogen.

B may be fully substituted, that is, may be substituted at any position not occupied by a bond shown in formula (II) or a bond to the remaining structure of the compound according to the invention, with C₆ to C₁₂ aryl. B may be fully substituted with phenyl.

X is a halogen atom selected from the group consisting of F, Cl, Br, and I. X may be or Br. X may be Cl.

The precursor compound having the formula (IIb) may be selected from I1 to I3

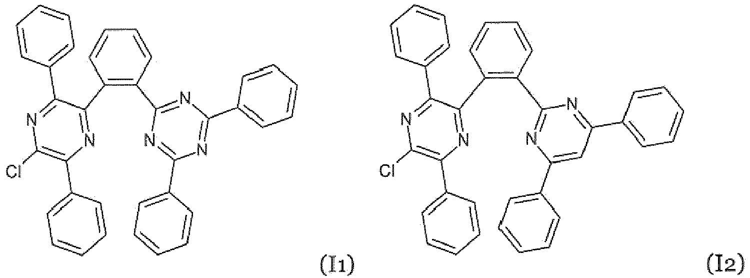

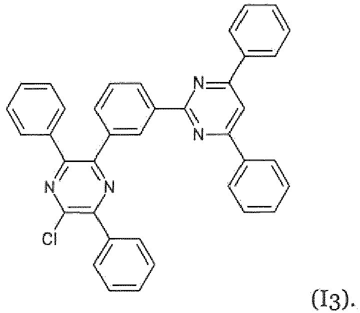

### Semiconducting material

According to one aspect, the invention is related to a semiconducting material comprising the compound in accordance with the invention as defined herein.

The semiconducting material maybe an organic semiconducting material. The semiconducting material may be an electron transporting material.

The semiconducting material may comprise the compound in accordance with the invention in an amount of at least 50 wt.-% with respect to the total weight of the semiconducting material. The semiconducting material may comprise the compound in accordance with the invention in an amount of at least 60 wt.-% with respect to the total weight of the semiconducting material. The semiconducting material may comprise the compound in accordance with the invention in an amount of at least 70 wt.-% with respect to the total weight of the semiconducting material. The semiconducting material may comprise the compound in accordance with the invention in an amount of at least 80 wt.-% with respect to the total weight of the semiconducting material. The semiconducting material may comprise the compound in accordance with the invention in an amount of at least 90 wt.-% with respect to the total weight of the semiconducting material. The semiconducting material may comprise the compound in accordance with the invention in an amount of at least 95 wt.-% with respect to the total weight of the semiconducting material. The semiconducting material may comprise the compound in accordance with the invention in an amount of at least 98 wt.-% with respect to the total weight of the semiconducting material. The semiconducting material may comprise the compound in accordance with the invention in an amount of at least 99 wt.-% with respect to the total weight of the semiconducting material. The semiconducting material may substantially consist of the compound in accordance with the invention. The semiconducting material may consist of the compound in accordance with the invention.

The semiconducting material may be undoped. Alternatively, the semiconducting material may be doped with an electrical n-type dopant.

Under n-type dopant it is understood a compound which, if embedded into an electron transport matrix material, improves, in comparison with the neat electron transport matrix material under the same physical conditions, the electron properties of the formed semiconducting material, particularly in terms of electron injection and/or electron conductivity.

In the context of the present invention "embedded into an electron transport matrix" means homogenously mixed with the electron transport matrix.

The n-type dopant may be selected from elemental metals, metal salts, metal complexes and organic radicals.

The metal salt can be selected from alkali metal salts and alkaline earth metal salts, in one embodiment from Li, Na, K, R, Cs, Mg, Ca, Sr and Ba salts. The salt may comprise anions selected from halogen anions, complex borate anions, organic phenolate anions. In one embodiment, the anions in the salt may be cation chelating anions, such as 8-hydroxyquinolinolate and/or 2-phosphoryl-phenolate.

In one embodiment, the n-type dopant is selected from alkali metal salts and alkali metal complexes; preferably from lithium salts and lithium organic complexes; more preferably from lithium halides and lithium organic chelates; even more preferably from lithium fluoride, a lithium quinolinolate, lithium borate, lithium phenolate, lithium pyridinolate or from a lithium complex with a Schiff base ligand; most preferably,
- the lithium complex has the formula II, III or IV: 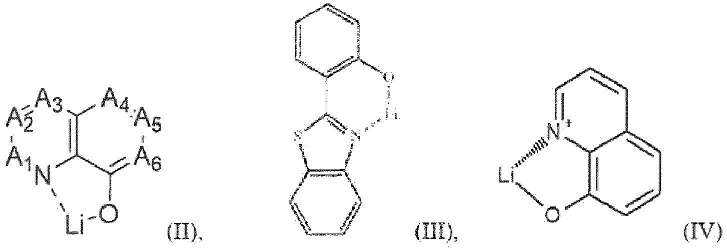 wherein
   A₁ to A₆ are same or independently selected from CH, CR, N, O;
   R is same or independently selected from hydrogen, halogen, alkyl or aryl or heteroaryl with 1 to 20 carbon atoms; and more preferred A₁ to A₆ are CH,
- the borate based organic ligand is a tetra(1H-pyrazol-1-yl)borate,
- the phenolate is a 2-(pyridin-2-yl)phenolate, a 2-phosphoryl-phenolate, such as 2-(diphenylphosphoryl)phenolate, an imidazol phenolate, 2-(pyridin-2-yl)phenolate or 2-(1-phenyl-1H-benzo[d]imidazol-2-yl)phenolate,
- the pyridinolate is a 2-(diphenylphosphoryl)pyridin-3-olate,

- the lithium Schiff base has the structure 100, 101, 102 or 103:

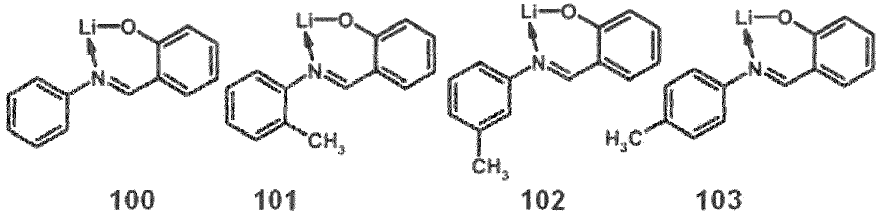

According to one embodiment of the invention, the semiconducting material of the present invention comprises a lithium organic complex, alternatively 8-Hydroxyquinolinolato-lithium (= LiQ).

### Organic electronic device

According to one aspect, the invention is related to an organic electronic device, such as an organic semiconducting device, comprising a semiconducting layer comprising the semiconducting material according to the invention. The semiconducting layer may consist of the semiconducting material according to the invention.

The semiconducting layer may be a hole blocking layer and/or an electron transport layer and/or an electron injection layer. The semiconducting layer may be a hole blocking layer.

The organic electronic device may further comprise an anode, a cathode and a light emission layer, wherein the light emission layer is arranged between the anode and the cathode, and the semiconducting layer is arranged between the light emission layer and the cathode.

The organic electronic device may further comprise an anode, a cathode, a light emission layer and an electron transport layer, wherein the light emission layer and the electron transport layer are arranged between the anode and the cathode, and the semiconducting layer is arranged between the light emission layer and the electron transport layer.

The organic electronic device may further comprise an anode, a cathode, a light emission layer and an electron transport layer, wherein the light emission layer and the electron transport layer are arranged between the anode and the cathode, and the semiconducting layer is arranged between the light emission layer and the electron transport layer, wherein the semiconducting layer is in direct contact with the light emission layer and/or the electron transport layer, preferably is in direct contact with the light emission layer and the electron transport layer.

The organic electronic device may be an organic light emitting diode.

The organic electronic device in accordance with the invention may comprise especially, besides the semiconducting layer comprising or consisting of the semiconducting material according to the invention, further layers. Exemplary embodiments of respective layers are described in the following:

### Substrate

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate or a silicon substrate.

### Anode electrode

Either a first electrode or a second electrode comprised in the inventive organic semiconducting device may be an anode electrode. The anode electrode may be formed by depositing or sputtering a material that is used to form the anode electrode. The material used to form the anode electrode may be a high work-function material, so as to facilitate hole injection. The anode material may also be selected from a low work function material (i.e. aluminum). The anode electrode may be a transparent or reflective electrode. Transparent conductive oxides, such as indium tin oxide (ITO), indium zinc oxide (IZO), tin-dioxide (SnO₂), aluminum zinc oxide (AlZO) and zinc oxide (ZnO), may be used to form the anode electrode.

The anode electrode may also be formed using metals, typically silver (Ag), gold (Au), or metal alloys.

### Hole injection layer

A hole injection layer (HIL) may be formed on the anode electrode by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500° C, a pressure of 10-8 to 10-3 Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The HIL may be formed of any compound that is commonly used to form a HIL. Examples of compounds that may be used to form the HIL include a phthalocyanine compound, such as copper phthalocyanine (CuPc), 4,4',4"-tris (3-methylphenylphenylamino) triphenylamine (m-MTDATA), TDATA, 2T-NATA, polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), and polyaniline)/poly(4-styrenesulfonate (PANI/PSS).

The HIL may comprise or consist of p-type dopant and the p-type dopant may be selected from tetrafluoro-tetracyanoquinonedimethane (F4TCNQ), 2,2'-(perfluoronaphthalen-2,6-diylidene) dimalononitrile or 2,2',2"-(cyclopropane-1,2,3-triylidene)tris(2-(p-cyanotetrafluorophenyl)acetonitrile) but not limited hereto. The HIL may be selected from a hole-transporting matrix compound doped with a p-type dopant. Typical examples of known doped hole transport materials are: copper phthalocyanine (CuPc), which HOMO level is approximately -5.2 eV, doped with tetrafluoro-tetracyanoquinonedimethane (F4TCNQ), which LUMO level is about -5.2 eV; zinc phthalocyanine (ZnPc) (HOMO = -5.2 eV) doped with F4TCNQ; α-NPD (N,N'-Bis(naphthalen-1-yl)-N,N'-bis(phenyl)-benzidine) doped with F4TCNQ. α-luPD doped with 2,2'-(perfluoronaphthalen-2,6-diylidene) dimalononitrile. The p-type dopant concentrations can be selected from 1 to 20 wt.-%, more preferably from 3 wt.-% to 10 wt.-%.

The thickness of the HIL may be in the range from about 1 nm to about 100 nm, and for example, from about 1 nm to about 25 nm. When the thickness of the HIL is within this range, the HIL may have excellent hole injecting characteristics, without a substantial penalty in driving voltage.

### Hole transport layer

A hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the compound that is used to form the HTL.

The HTL may be formed of any compound that is commonly used to form a HTL. Compounds that can be suitably used are disclosed for example in Yasuhiko Shirota and Hiroshi Kageyama, Chem. Rev. 2007, 107, 953-1010 and incorporated by reference. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

### Electron blocking layer

The function of an electron blocking layer (EBL) is to prevent electrons from being transferred from an emission layer to the hole transport layer and thereby confine electrons to the emission layer. Thereby, efficiency, operating voltage and/or lifetime are improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

### Photoactive layer (PAL)

The photoactive layer converts an electrical current into photons or photons into an electrical current.

The PAL may be formed on the HTL by vacuum deposition, spin coating, slot-die coating, printing, casting, LB deposition, or the like. When the PAL is formed using vacuum deposition or spin coating, the conditions for deposition and coating may be similar to those for the formation of the HIL. However, the conditions for deposition and coating may vary, according to the compound that is used to form the PAL.

It may be provided that the photoactive layer does not comprise the compound according to the invention.

The photoactive layer may be a light-emitting layer or a light-absorbing layer.

### Emission layer (EML)

The EML may be formed on the HTL by vacuum deposition, spin coating, slot-die coating, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

It may be provided that the emission layer does not comprise the compound according to the invention.

The respective emission layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA), bis(2-(2-hydroxyphenyl)benzo-thiazolate)zinc (Zn(BTZ)₂), EML3 below, Compound 1 below, and Compound 2 below.

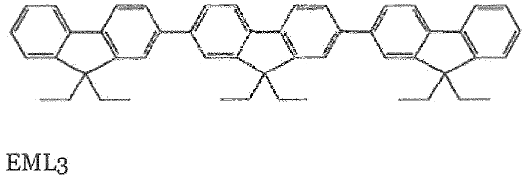

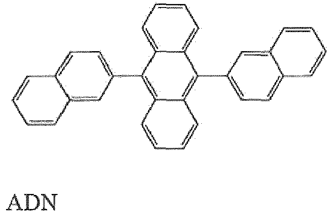

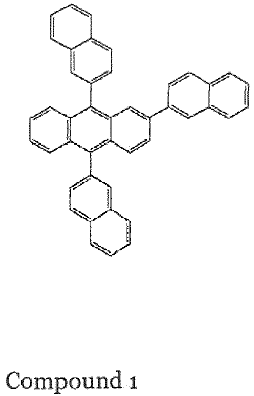

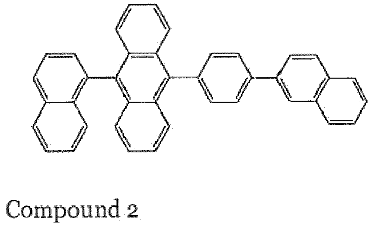

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)₃, and Btp₂lr(acac), but are not limited thereto. These compounds are phosphorescent emitters, however, fluorescent red emitter dopants could also be used.

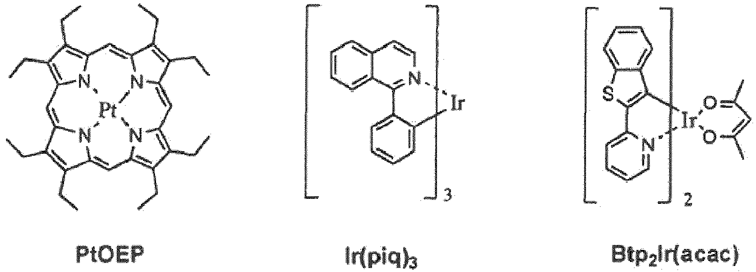

Examples of phosphorescent green emitter dopants are Ir(ppy)₃ (ppy = phenylpyridine), Ir(ppy)₂(acac), Ir(mpyp)₃ are shown below. Compound 3 is an example of a fluorescent green emitter and the structure is shown below.

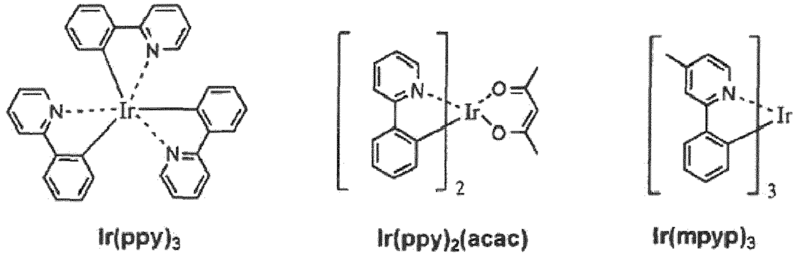

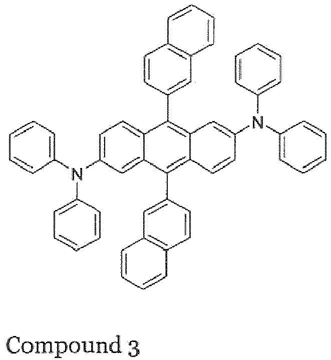

Examples of phosphorescent blue emitter dopants are F2Irpic, (F2ppy)2Ir(tmd) and Ir(dfppz)3, ter-fluorene, the structures are shown below. 4.4'-bis(4-diphenyl amiostyryl)biphenyl (DPAVBi), 2,5,8,11-tetra-tert-butyl perylene (TBPe), and Compound 4 below are examples of fluorescent blue emitter dopants.

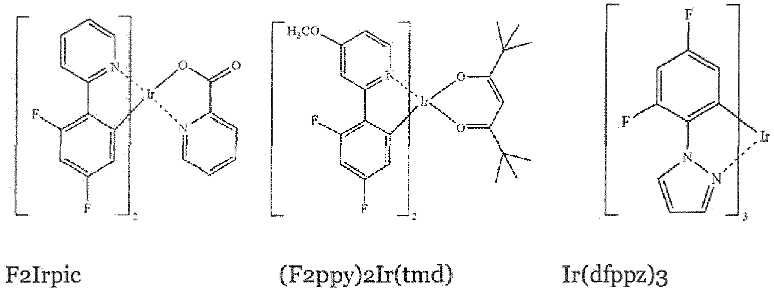

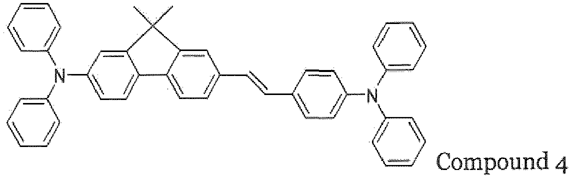

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

### Hole blocking layer (HBL)

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, and phenanthroline derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

The hole blocking layer may be made of a semiconducting material according to the invention, that is may comprise or consist of the compound in accordance with the present invention.

### Electron transport layer (ETL)

The semiconducting device according to the present invention may comprise an electron transport layer (ETL).

According to various embodiments the OLED may comprise an electron transport layer or an electron transport layer stack comprising at least a first electron transport layer and at least a second electron transport layer.

By suitably adjusting energy levels of particular layers of the ETL, the injection and transport of the electrons may be controlled, and the holes may be efficiently blocked. Thus, the OLED may have long lifetime.

The electron transport layer may comprise ETM materials comprising one or more electron transport compound(s) known in the art.

According to an embodiment, the electron transport layer comprises an electron transport compound, wherein the electron transport compound comprises 8 to 13 aromatic or heteroaromatic rings, optionally 8 to 11 aromatic or heteroaromatic rings, optionally 9 to 11 aromatic or heteroaromatic rings, and optionally 9 aromatic or heteroaromatic rings, wherein one or more of the aromatic or heteroaromatic rings may be substituted with C₁ to C₄ alkyl. In this regard, an aromatic, respectively heteroaromatic ring is a single aromatic ring, for example a 6-membered aromatic ring such as phenyl, a 6-membered heteroaromatic ring such as pyridyl, a 5-membered heteroaromatic ring such as pyrrolyl etc. In a system of condensed (hetero)aromatic rings, each ring is considered as a single ring in this regard. For example, naphthalene comprises two aromatic rings.

The electron transport compound may comprise at least one heteroaromatic ring, optionally 1 to 5 heteroaromatic rings, optionally 1 to 4 heteroaromatic rings, optionally 1 to 3 heteroaromatic rings, and optionally 1 or 2 heteroaromatic rings.

The aromatic or heteroaromatic rings of the electron transport compound may be 6-membered rings.

The heteroaromatic rings of the electron transport compound may be a N-containing heteroaromatic ring, optionally all of the heteroaromatic rings are N-containing heteroaromatic rings, optionally all of the heteroaromatic rings heteroaromatic rings contain N as the only type of heteroatom.

The electron transport compound may comprise at least one six-member heteroaromatic ring containing one to three N-atoms in each heteroaromatic ring, optionally one to three 6-membered heteroaromatic rings containing one to three N-atoms in each heteroaromatic ring, respectively.

The at least one 6-membered heteroaromatic ring comprised in the electron transport compound may be an azine. The at least one 6-membered heteroaromatic ring comprised in the electron transport compound may be triazine, diazine, pyrazine, pyrimidine, pyridine, quinazoline or bonzoquinazoline, preferably triazine.

If the electron transport compound comprises two or more heteroaromatic rings, the heteroaromatic rings may be separated from each other by at least one aromatic ring which is free of a heteroatom.

In an embodiment, the heteroatoms in the heteroaromatic rings of the electron transport compound are bound into the molecular structure of the electron transport compound by at least one double bond.

Further, the electron transport layer may comprise one or more additives. The additive may be an n-type dopant. The additive can be alkali metal, alkali metal compound, alkaline earth metal, alkaline earth metal compound, transition metal, transition metal compound or a rare earth metal. In another embodiment, the metal can be one selected from a group consisting of Li, Na, K, Rb, Cs, Mg, Ca, Sr, Ba, La, Ce, Sm, Eu, Tb, Dy, and Yb. In another emdodiment, the n-type dopant can be one selected from a group consisting of Cs, K, Rb, Mg, Na, Ca, Sr, Eu and Yb. In an embodiment the alkali metal compound may be 8-Hydroxyquinolinolato-lithium (LiQ), Lithium tetra(1H-pyrazol-1-yl)borate or Lithium 2-(diphenylphosphoryl)phenolate. Suitable compounds for the ETM (which may be used in addition to the inventive compound as defined above) are not particularly limited. In one embodiment, the electron transport matrix compounds consist of covalently bound atoms. Preferably, the electron transport matrix compound comprises a conjugated system of at least 6, more preferably of at least 10 delocalized electrons. In one embodiment, the conjugated system of delocalized electrons may be comprised in aromatic or heteroaromatic structural moieties, as disclosed e.g. in documents EP 1 970 371 A1 or WO 2013/079217 A1.

The electron transport layer may comprise the compound according to the invention.

### Electron injection layer (EIL)

The optional EIL, which may facilitates injection of electrons from the cathode, may be formed on the ETL, preferably directly on the electron transport layer. Examples of materials for forming the EIL include lithium 8-hydroxyquinolinolate (LiQ), LiF, NaCl, CsF, Li₂O, BaO, Ca, Ba, Yb, Mg, especially Yb which are known in the art. Deposition and coating conditions for forming the EIL are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

The electron injection layer may comprise the compound according to the invention.

### Cathode electrode

The cathode electrode is formed on the EIL if present. The cathode electrode may be formed of a metal, an alloy, an electrically conductive compound, or a mixture thereof. The cathode electrode may have a low work function. For example, the cathode electrode may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode electrode may be formed of a transparent conductive oxide, such as ITO or IZO. The cathode may comprise more that 50 volume % of metal selected from Ag and Au.

The thickness of the cathode electrode may be in the range from about 5 nm to about 1000 nm, for example, in the range from about 10 nm to about 100 nm. When the thickness of the cathode electrode is in the range from about 5 nm to about 50 nm, the cathode electrode may be transparent or semitransparent even if formed from a metal or metal alloy.

The cathode may be a semi-transparent metal cathode having a thickness less than 20 nm, preferably less than 15 nm.

It is to be understood that the cathode electrode is not part of an electron injection layer or the electron transport layer.

### Charge generation layer/hole generation layer

The charge generation layer (CGL) is composed of a double layer.

The charge generation layer is a pn junction joining an n-type charge generation layer (electron generation layer) and a p-type charge generation layer (hole generation layer). The n-side of the pn junction generates electrons and injects them into the layer which is adjacent in the direction to the anode. Analogously, the p-side of the p-n junction generates holes and injects them into the layer which is adjacent in the direction to the cathode.

Charge generation layers are used in tandem devices, for example, in tandem OLEDs comprising, between two electrodes, two or more emission layers. In a tandem OLED comprising two emission layers, the n-type charge generation layer provides electrons for the first light emission layer arranged near the anode, while the p-type charge generation layer provides holes to the second light emission layer arranged between the first emission layer and the cathode.

The hole generation layer can be composed of an organic matrix material doped with p-type dopant. Suitable matrix materials for the hole generation layer may be materials conventionally used as hole injection and/or hole transport matrix materials. Also, p-type dopant used for the hole generation layer can employ conventional materials. For example, the p-type dopant can be one selected from a group consisting of tetrafluore-7,7,8,8-tetracyanoquinodimethane (F4-TCNQ), derivatives of tetracyanoquinodimethane, radialene derivatives, iodine, FeCl3, FeF3, and SbCl5. Also, the host can be one selected from a group consisting of N,N'-di(naphthalen-1-yl)-N,N-diphenyl-benzidine (NPB), N,N'-diphenyl-N,N'-bis(3-methylphenyl)-1,1-biphenyl-4,4'-diamine (TPD) and N,N',N'-tetranaphthyl-benzidine (TNB).

The n-type charge generation layer can be layer of a neat n-dopant, for example of an electropositive metal, or can consist of an organic matrix material doped with the n-dopant. In one embodiment, the n-type dopant can be alkali metal, alkali metal compound, alkaline earth metal, or alkaline earth metal compound. In another embodiment, the metal can be one selected from a group consisting of Li, Na, K, Rb, Cs, Mg, Ca, Sr, Ba, La, Ce, Sm, Eu, Tb, Dy, and Yb. More specifically, the n-type dopant can be one selected from a group consisting of Cs, K, Rb, Mg, Na, Ca, Sr, Eu and Yb. Suitable matrix materials for the electron generating layer may be the materials conventionally used as matrix materials for electron injection or electron transport layers. The matrix material can be for example one selected from a group consisting of triazine compounds, hydroxyquinoline derivatives like tris(8-hydroxyquinoline) aluminum, benzazole derivatives, and silole derivatives.

In one embodiment, the p-type charge generation layer may include compounds of the following Chemical Formula X. 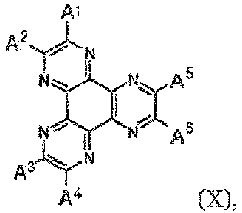 wherein each of A1 to A6 may be hydrogen, a halogen atom, nitrile (-CN), nitro (-NO2), sulfonyl (-SO2R), sulfoxide (-SOR), sulfonamide (-SO2NR), sulfonate (-SO3R), trifluoromethyl (-CF3), ester (-COOR), amide (-CONHR or - CONRR'), substituted or unsubstituted straight-chain or branched-chain C1-C12 alkoxy, substituted or unsubstituted straight-chain or branched-chain C1-C12 alkyl, substituted or unsubstituted straight-chain or branched chain C2-C12 alkenyl, a substituted or unsubstituted aromatic or non-aromatic heteroring, substituted or unsubstituted aryl, substituted or unsubstituted mono- or di-arylamine, substituted or unsubstituted aralkylamine, or the like. Herein, each of the above R and R' may be substituted or unsubstituted C1-C60 alkyl, substituted or unsubstituted aryl, or a substituted or unsubstituted 5- to 7-membered heteroring, or the like.

An example of such p-type charge generation layer may be a layer comprising CNHAT

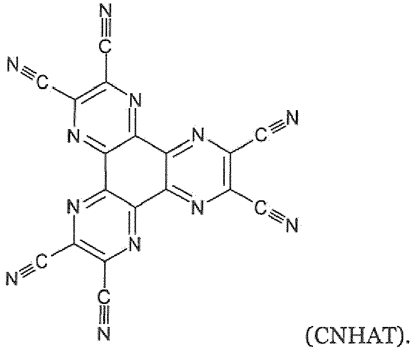

The hole generating layer may be arranged on top of the n-type charge generation layer.

With regard to the method for producing the organic electronic device, the alternative embodiments outlined above may be applied mutatis mutandis. For example, the charge generation layer may be produced with an interlayer provided between the n-type sub-layer, and the p-type sub-layer.

According to one aspect, the OLED according to the present invention can comprise a layer structure of a substrate that is adjacent arranged to an anode electrode, the anode electrode is adjacent arranged to a first hole injection layer, the first hole injection layer is adjacent arranged to a first hole transport layer, the first hole transport layer is adjacent arranged to a first electron blocking layer, the first electron blocking layer is adjacent arranged to a first emission layer, the first emission layer is adjacent arranged to a first electron transport layer, the first electron transport layer is adjacent arranged to an n-type charge generation layer (n-type sub-layer), the n-type charge generation layer is adjacent arranged to a hole generating layer (p-type sub-layer), an interlayer may be provided between the n-type sub-layer, and the p-type sub-layer, the hole generating layer is adjacent arranged to a second hole transport layer, the second hole transport layer is adjacent arranged to a second electron blocking layer, the second electron blocking layer is adjacent arranged to a second emission layer, between the second emission layer and the cathode electrode an optional electron transport layer and/or an optional injection layer are arranged.

### Display device

According to a further aspect, the invention is related to a display device comprising the organic electronic device according to the invention, wherein the organic electronic device is an organic light emitting device.

### Process for preparing the organic electronic device

According to a further aspect, the invention is related to a process for preparing the organic electronic device according to the present invention, wherein the process comprises a step of depositing the compound according to the present invention on a solid support.

The method for depositing may comprise:
- deposition via vacuum thermal evaporation;
- deposition via solution processing, preferably the processing is selected from spin-coating, printing, casting; and/or
- slot-die coating.

### Details and definitions of the invention

An organic compound as referred to herein is generally any chemical compound that contains carbon (except some compounds generally referred to as being inorganic, such as carbonates, cyanides, carbon dioxide, diamond etc.). The term organic compound used herein also encompasses compounds such as organometallic compounds, for example metallocenes etc.

If not mentioned else explicitly, all compounds, groups, moieties, substituents etc. shown herein, especially by structural formulas, by systematic names etc. encompass the respective partially and fully deuteriated derivatives thereof.

The term "zero-valent" as used herein refers to a metal in the oxidation state o, i.e. particular to metals from which no electron has been removed. The zero-valent metal may be present in the form of zero-valent atoms, neat metal, alloys etc.

The term "trivalent" as used herein refers to a nitrogen atom with a single bond and a double bond and containing a lone pair of electrons.

The term "hydrocarbyl group" as used herein shall be understood to encompass any organic group comprising carbon atoms, in particular organic groups, such as alkyl, aryl, heteroaryl, heteroalkyl, in particular such groups which are substituents usual in organic electronics.

The term "conjugated system" as used herein refer to a system of alternating π- and σ-bonds or a molecule having alternating single and multiple bonds i.e. double bond or a system having one or more two-atom structural units having the π-bond between its atoms can be replaced by an atom bearing at least one lone electron pair, typically by a divalent O or S atom.

The term "alkyl" as used herein shall encompass linear as well as branched and cyclic alkyl. For example, C3-alkyl may be selected from n-propyl and iso-propyl. Likewise, C4-alkyl encompasses n-butyl, sec-butyl and t-butyl. Likewise, C6-alkyl encompasses n-hexyl and cyclohexyl.

The subscribed number n in Cₙ relates to the total number of carbon atoms in the respective alkyl, arylene, heteroarylene or aryl group.

The term "aryl" or "arylene" as used herein shall encompass phenyl (C₆-aryl), fused aromatics, such as naphthalene, anthracene, phenanthrene, tetracene etc.. Further encompassed are biphenyl and oligo- or polyphenyls, such as terphenyl, phenyl-substituted biphenyl, phenyl-substituted terphenyl (such as tetraphenyl benzole groups) etc.. "Arylene" respectively "heteroarylene", refers to groups to which two further moieties are attached. In the present specification, the term "aryl group" or "arylene group" may refer to a group comprising at least one hydrocarbon aromatic moiety, and all the elements of the hydrocarbon aromatic moiety may have p-orbitals which form conjugation, for example a phenyl group, a napthyl group, an anthracenyl group, a phenanthrenyl group, a pyrinyl group, a fluorenyl group and the like. Further encompoassed are spiro compounds in which two aromatic moieties are connected with each other via a spiro-atom, such as 9,9'-spirobi[9H-fluorene]yl. The aryl or arylene group may include a monocyclic or fused ring polycyclic (i.e., links sharing adjacent pairs of carbon atoms) functional group.

The term "heteroaryl" as used herein refers to aryl groups in which at least one carbon atom is substituted with a heteroatom. The term "heteroaryl" may refer to aromatic heterocycles with at least one heteroatom, and all the elements of the hydrocarbon heteroaromatic moiety may have p-orbitals which form conjugation. The heteroatom may be selected from N, O, S, B, Si, P, Se, preferably from N, O and S. A heteroarylene ring may comprise at least 1 to 3 heteroatoms. Preferably, a heteroarylene ring may comprise at least 1 to 3 heteroatoms individually selected from N, S and/or O. Just as in case of "aryl"/"arylene", the term "heteroaryl" comprises, for example, spiro compounds in which two aromatic moieties are connected with each other, such as spiro[fluorene-9,9'-xanthene]. Further exemplary heteroaryl groups are diazine, triazine, dibenzofurane, dibenzothiofurane, acridine, benzoacridine, dibenzoacridine etc.

The subscripted number n in Cₙ-heteroaryl merely refers to the number of carbon atoms excluding the number of heteroatoms. In this context, it is clear that a C₃ heteroarylene group is an aromatic compound comprising three carbon atoms, such as pyrazol, imidazole, oxazole, thiazole and the like.

The term "halogenated" refers to an organic compound in which one hydrogen atom thereof is replaced by a halogen atom. The term "perhalogenated" refers to an organic compound in which all of the hydrogen atoms thereof are replaced by halogen atoms. The meaning of the terms "fluorinated" and "perfluorinated" should be understood analogously.

The term "alkenyl" as used herein refers to a group -CR¹ = CR²R³ comprising a carbon-carbon double bond.

The term "perhalogenated" as used herein refers to a hydrocarbyl group wherein all of the hydrogen atoms of the hydrocarbyl group are replaced by halogen (F, Cl, Br, I) atoms.

The term "alkoxy" as used herein refers to a structural fragment of the Formula -OR with R being hydrocarbyl, preferably alkyl or cycloalkyl.

The term "thioalkyl" as used herein refers to a structural fragment of the Formula -SR with R being hydrocarbyl, preferably alkyl or cycloalkyl.

In the present specification, the term single bond refers to a direct bond.

In terms of the invention, a group is "substituted with" another group if one of the hydrogen atoms comprised in this group is replaced by another group, wherein the other group is the substituent.

In accordance with the present disclosure, in a formula showing the following binding situation, 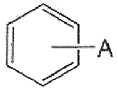 the arbitrary group A may be bound to any suitable binding position. In a situation were it is shown that the bond of A crosses more than one ring 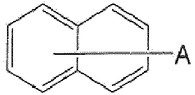 the arbitrary group A may be bound to any suitable binding position of each ring crossed with the bond.

In terms of the invention, the expression "between" with respect to one layer being between two other layers does not exclude the presence of further layers which may be arranged between the one layer and one of the two other layers. In terms of the invention, the expression "in direct contact" with respect to two layers being in direct contact with each other means that no further layer is arranged between those two layers. One layer deposited on the top of another layer is deemed to be in direct contact with this layer.

In the context of the present specification the term "essentially non-emissive" or "non-emissive" means that the contribution of the compound or layer to the visible emission spectrum from the device is less than 10 %, preferably less than 5 % relative to the visible emission spectrum. The visible emission spectrum is an emission spectrum with a wavelength of about ≥ 380 nm to about ≤ 780 nm.

With respect to the inventive organic light emitting device, the compounds mentioned in the experimental part may be most preferred.

The organic electroluminescent device (OLED) may be a bottom- or top-emission device.

Another aspect is directed to a device comprising at least one organic electroluminescent device (OLED). A device comprising organic light-emitting diodes is for example a display or a lighting panel.

In the present invention, the following defined terms, these definitions shall be applied, unless a different definition is given in the claims or elsewhere in this specification.

In the context of the present specification the term "different" or "differs" in connection with the matrix material means that the matrix material differs in their structural formula.

The energy levels of the highest occupied molecular orbital, also named HOMO, and of the lowest unoccupied molecular orbital, also named LUMO, are measured in electron volt (eV).

The terms "OLED" and "organic light-emitting diode" are simultaneously used and have the same meaning. The term "organic electroluminescent device" as used herein may comprise both organic light emitting diodes as well as organic light emitting transistors (OLETs).

As used herein, "weight percent", "wt.-%", wt%, "percent by weight", "% by weight", and variations thereof refer to a composition, component, substance or agent as the weight of that component, substance or agent of the respective electron transport layer divided by the total weight of the respective electron transport layer thereof and multiplied by 100. It is understood that the total weight percent amount of all components, substances and agents of the respective electron transport layer and electron injection layer are selected such that it does not exceed 100 wt.-%.

As used herein, "volume percent", "vol.-%", "percent by volume", "% by volume", and variations thereof refer to a composition, component, substance or agent as the volume of that component, substance or agent of the respective electron transport layer divided by the total volume of the respective electron transport layer thereof and multiplied by 100. It is understood that the total volume percent amount of all components, substances and agents of the cathode layer are selected such that it does not exceed 100 vol.-%.

All numeric values are herein assumed to be modified by the term "about", whether or not explicitly indicated. As used herein, the term "about" refers to variation in the numerical quantity that can occur. Whether or not modified by the term "about" the claims include equivalents to the quantities.

It should be noted that, as used in this specification and the appended claims, the singular forms "a", "an", and "the" include plural referents unless the content clearly dictates otherwise.

The term "free of", "does not contain", "does not comprise" does not exclude impurities. Impurities have no technical effect with respect to the object achieved by the present invention. The term "free of" a compound means that such compound/material is not deliberately added to the layer during processing.

Preferably, the semiconducting layer comprising the compound according to the invention is essentially non-emissive or non-emitting.

The operating voltage, also named U, is measured in Volt (V) at 10 milliAmpere per square centimeter (mA/cm²).

The candela per Ampere efficiency, also named cd/A efficiency is measured in candela per ampere at 10 milliAmpere per square centimeter (mA/cm2).

The external quantum efficiency, also named EQE, is measured in percent (%).

The color space is described by coordinates CIE-x and CIE-y (International Commission on Illumination 1931). For blue emission the CIE-y is of particular importance. A smaller CIE-y denotes a deeper blue color. Efficiency values are compared at the same CIE-y.

The highest occupied molecular orbital, also named HOMO, and lowest unoccupied molecular orbital, also named LUMO, are measured in electron volt (eV).

The term "OLED", "organic light emitting diode", "organic light emitting device", "organic optoelectronic device" and "organic light-emitting diode" are simultaneously used and have the same meaning.

The term "life-span" and "lifetime" are simultaneously used and have the same meaning.

The anode and cathode may be described as anode electrode / cathode electrode or anode electrode / cathode electrode or anode electrode layer / cathode electrode layer.

Room temperature, also named ambient temperature, is 23°C.

Hereinafter, the embodiments are illustrated in more detail with reference to examples. However, the present disclosure is not limited to the following examples. Reference will now be made in detail to the exemplary aspects.

### DESCRIPTION OF THE DRAWINGS

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object of the invention are disclosed in the dependent claims and the following description of the respective figures which in an exemplary fashion show preferred embodiments according to the invention. Any embodiment does not necessarily represent the full scope of the invention, however, and reference is made therefore to the claims and herein for interpreting the scope of the invention. It is to be understood that both the foregoing general description and the following detailed description are exemplary and explanatory only and are intended to provide further explanation of the present invention as claimed.
FIG. 1 is a schematic sectional view of an organic semiconducting device, according to an exemplary embodiment of the present invention;
FIG. 2 is a schematic sectional view of an organic light-emitting diode (OLED), according to an exemplary embodiment of the present invention;
FIG. 3 is a schematic sectional view of an OLED, according to an exemplary embodiment of the present invention.
FIG. 4 is a schematic sectional view of an OLED comprising a charge generation layer and two emission layers, according to an exemplary embodiment of the present invention.

Hereinafter, the figures are illustrated in more detail with reference to examples. However, the present disclosure is not limited to the following figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

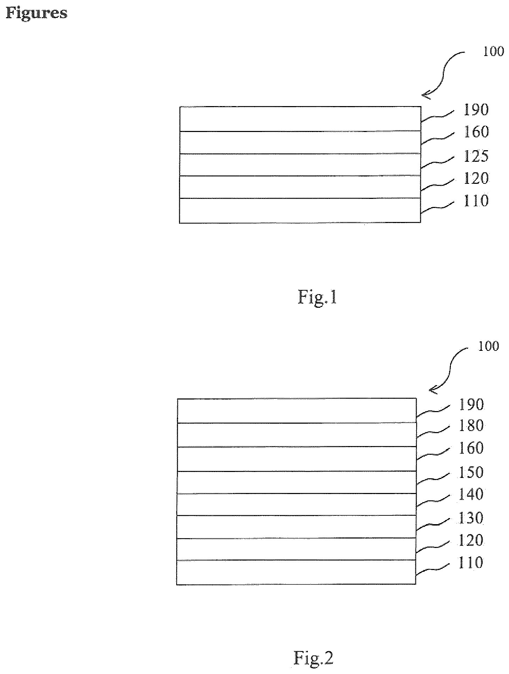

FIG. 1 is a schematic sectional view of an organic semiconducting device 100, according to an exemplary embodiment of the present invention. The organic semiconducting device 100 includes a substrate 110, an anode 120, a light emission layer (EML) 125, a semiconducting layer comprising or consisting of the semiconducting material according to the invention 160. The semiconducting layer comprising or consisting of the semiconducting material according to the invention 160 is formed on the EML 125. Onto the organic semiconductor layer 160, a cathode 190 is disposed.

FIG. 2 is a schematic sectional view of an organic light-emitting diode (OLED) 100, according to an exemplary embodiment of the present invention. The OLED 100 includes a substrate 110, an anode 120, a hole injection layer (HIL) 130, a hole transport layer (HTL) 140, an emission layer (EML) 150, an electron transport layer (ETL) 160. In this embodiment, the electron transport layer is the semiconducting layer according to the invention. The electron transport layer (ETL) 160 is formed on the EML 150. Onto the electron transport layer (ETL) 160, an electron injection layer (EIL) 180 is disposed. The cathode 190 is disposed directly onto the electron injection layer (EIL) 180.

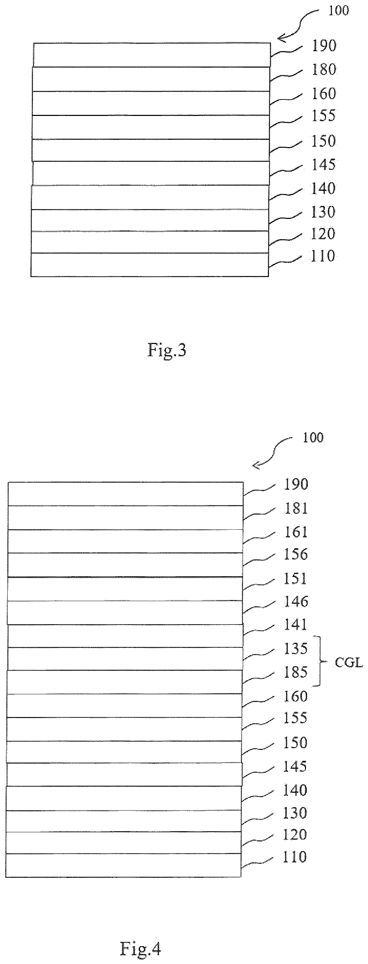

Fig. 3 is a schematic sectional view of an OLED 100, according to another exemplary embodiment of the present invention. Fig. 3 differs from Fig. 2 in that the OLED 100 of Fig. 3 comprises an electron blocking layer (EBL) 145 and a hole blocking layer (HBL) 155.

Referring to Fig. 3, the OLED 100 includes a substrate 110, an anode 120, a hole injection layer (HIL) 130, a hole transport layer (HTL) 140, an electron blocking layer (EBL) 145, an emission layer (EML) 150, a hole blocking layer (HBL) 155, an electron transport layer (ETL) 160, an electron injection layer (EIL) 180 and a cathode electrode 190.

In this embodiment of Fig. 3, the HBL 155 is the semiconducting layer comprising the compound according to the present invention.

Fig. 4 is a schematic sectional view of an OLED 100, according to another exemplary embodiment of the present invention. Fig. 4 differs from Fig. 3 in that the OLED 100 of Fig. 4 further comprises a charge generation layer (CGL) and a second emission layer (151).

Referring to Fig. 4, the OLED 100 includes a substrate 110, an anode 120, a first hole injection layer (HIL) 130, a first hole transport layer (HTL) 140, a first electron blocking layer (EBL) 145, a first emission layer (EML) 150, a first hole blocking layer (HBL) 155, a first electron transport layer (ETL) 160, an n-type charge generation layer (n-type CGL) 185, a hole generating layer (p-type charge generation layer; p-type GCL) 135, a second hole transport layer (HTL) 141, a second electron blocking layer (EBL) 146, a second emission layer (EML) 151, a second hole blocking layer (EBL) 156, a second electron transport layer (ETL) 161, a second electron injection layer (EIL) 181 and a cathode 190.

In this embodiment of Fig. 4, the HBL 155 is the semiconducting layer comprising the compound according to the present invention.

While not shown in Fig. 1, Fig. 2, Fig. 3 and Fig. 4, a sealing layer may further be formed on the cathode electrodes 190, in order to seal the OLEDs 100. In addition, various other modifications may be applied thereto.

Hereinafter, the embodiments are illustrated in more detail with reference to examples. However, the present disclosure is not limited to the following examples.

### Synthesis procedures

In the following synthesis descriptions, dichloromethane is abbreviated as DCM, tetrahydrofuran as THF.

### 2-(2-(5-(5,5-dimethyl-5H-dibenzo[b,d]silol-3-yl)-3,6-diphenylpyrazin-2-yl)phenyl)-4,6-diphenyl-1,3,5-triazine (E1)

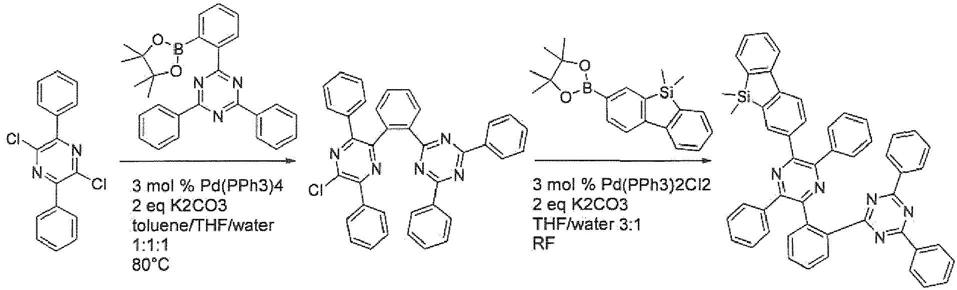

### 1) 2-(2-(5-chloro-3,6-diphenylpyrazin-2-yl)phenyl)-4,6-diphenyl-1,3,5-triazine (I1)

A three-neck round-bottom flask was flushed with nitrogen and charged with 2,5-dichloro-3,6-diphenylpyrazine (CAS 74134-61-5, 1.00 eq, 41.5 g), 2,4-diphenyl-6-(2-(4,4,5,5-tetramethyl-1,3,2-dioxaborolan-2-yl)phenyl)-1,3,5-triazine (CAS 1696425-27-0, 1.3 eq, 78.0 g), tetrakis(triphenylphosphine)palladium(o) (CAS 14221-01-3, 0.03 eq, 5.4 g), potassium carbonate (CAS 584-08-7, 2.0 eq, 38.0 g). A deaerated mixture of 137 mL toluene, 137 mL THF and 137 mL water was added. The reaction ran at 8o°C under nitrogen atmosphere overnight. After cooling down to room temperature, a brown suspension formed. The raw solid material was filtered, washed with THF, water and hexane. The resulting solid was dissolved in DCM, the solution filtered through a silica pad, evaporated and dried. Final purification was done by sublimation. Yield: 46 g (58 %).

### 2) 2-(2-(5-(5,5-dimethyl-5H-dibenzo[b,d]silol-3-yl)-3,6-diphenylpyrazin-2-yl)phenyl)-4,6-diphenyl-1,3,5-triazine (E1)

A three-neck round-bottom flask was flushed with nitrogen and charged with 2-(2-(5-chloro-3,6-diphenylpyrazin-2-yl)phenyl)-4,6-diphenyl-1,3,5-triazine (1.00 eq, 14.0 g), 5,5-dimethyl-3-(4,4,5,5-tetramethyl-1,3,2-dioxaborolan-2-yl)-5H-dibenzo[b,d]silole (CAS 1262528-40-4, 1.3 eq, 10.7 g), bis(triphenylphosphine)-palladium-II-chloride (CAS 13965-03-2, 0.03 eq, 0.5 g), potassium carbonate (CAS 584-08-7, 2.0 eq, 6.7 g). A deaerated mixture of 75 mL THF and 25 mL water was added. The reaction ran at reflux under nitrogen atmosphere overnight. The reaction mixture was cooled down, the solvent was evaporated and toluene was added. The formed solid was filtered and washed with water and methanol. The raw product was dissolved in 800 mL chloroform, the solution filtered through a silica pad, the filtrate was partially evaporated and a mixture of methanol in DCM (5:95 v/v) was added. A white precipitate formed. The solid was filtered, dried and purified by sublimation. White powder. Yield: 9.1 g (51 %), ESI-MS: 748 (M+H).

### 2-(2-(5-(5,5-dimethyl-5H-dibenzo[b,d]silol-3-yl)-3,6-diphenylpyrazin-2-yl)phenyl)-4,6-diphenylpyrimidine (E2)

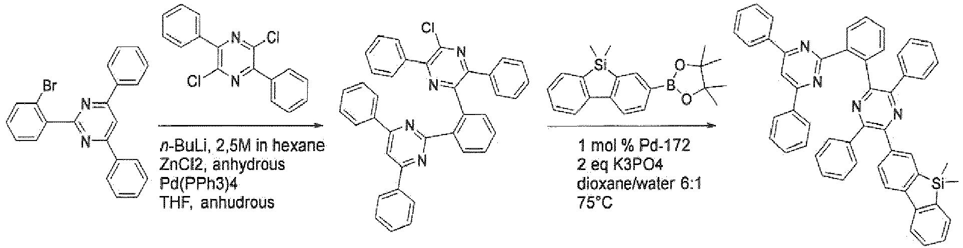

### 1) 2-(2-(5-chloro-3,6-diphenylpyrazin-2-yl)phenyl)-4,6-diphenylpyrimidine (I2)

A three-neck round-bottom flask was flushed with nitrogen and charged with 2-(2-bromophenyl)-4,6-diphenylpyrimidine (CAS 2435673-56-4, 1.00 eq, 19.1 g) in 180 mL anhydrous THF. The mixture was cooled to -8o°C and 24 mL of a 2.5 M n-butyllithium solution in hexanes (CAS 109-72-8/110-54-3, 1.2 eq) were added dropwise. After one hour, a solution of 8.8 g zinc(II)chloride (CAS 7646-85-7, 1.3 eq) in 60 mL dry THF was added. The reaction mixture was stired for one hour while it warmed to room temperature. Then, 2,5-dichloro-3,6-diphenylpyrazine (CAS 74134-61-5, 1.3 eq, 19.3 g) and tetrakis(triphenylphosphine)palladium(o) (CAS 14221-01-3, 0.05 eq, 2.9 g) were added. The reaction ran seven hours at reflux. Next morning, 30 mL methanol was added and the mixture was concentrated under reduced pressure. Water was added and the mixture was extracted with dichloromethane. Combined organic phases were dried and the raw product was purified with column chromatography (DCM/petroleum ether 1:1 v/v). Yield: 17.3 g (61 %).

### 2) 2-(2-(5-(5,5-dimethyl-5H-dibenzo[b,d]silol-3-yl)-3,6-diphenylpyrazin-2-yl)phenyl)-4,6-diphenylpyrimidine (E2)

A three-neck round-bottom flask was flushed with nitrogen and charged with 2-(2-(5-chloro-3,6-diphenylpyrazin-2-yl)phenyl)-4,6-diphenylpyrimidine (1 eq, 16.5 g), 5,5-dimethyl-3-(4,4,5,5-tetramethyl-1,3,2-dioxaborolan-2-yl)-5H-dibenzo[b,d]silole (CAS 1262528-40-4, 1.3 eq, 12.6 g), chloro(crotyl)(2-dicyclohexylphosphino-2',6'-dimethoxybiphenyl)palladium(II) (CAS 1798781-99-3, 0,01 eq, 0.2 g), potassium phosphate (CAS 7778-53-2, 2 eq, 12.6 g). A deaerated mixture of 180 mL dioxane and 30 mL water was added. The reaction ran at 75°C under nitrogen atmosphere overnight. The reaction mixture was cooled down, the formed solid filtered and washed with dioxane and methanol. Further purification was done by flash chromatography on silica gel with chloroform. Final purification was done by sublimation. White powder. Yield: 4.9 g (22 %), ESI-MS: 747 (M+H).

### 2-(3-(5-(5,5-dimethyl-5H-dibenzo[b,d]silol-3-yl)-3,6-diphenylpyrazin-2-yl)phenyl)-4,6-diphenylpyrimidine (E3)

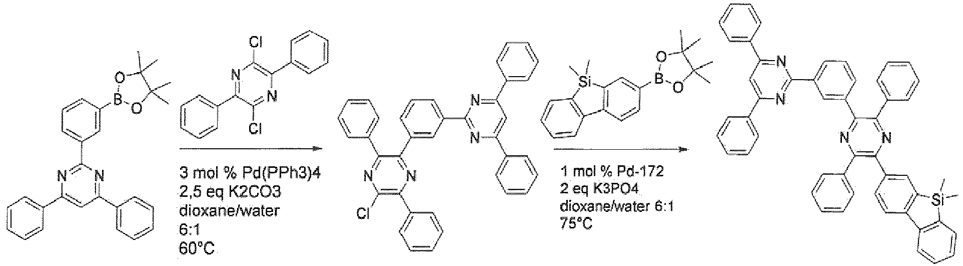

### 1) 2-(3-(5-chloro-3,6-diphenylpyrazin-2-yl)phenyl)-4,6-diphenylpyrimidine (13)

A three-neck round-bottom flask was flushed with nitrogen and charged with 2,5-dichloro-3,6-diphenylpyrazine (CAS 74134-61-5, 1.05 eq, 27.6 g), 4,6-diphenyl-2-(3-(4,4,5,5-tetramethyl-1,3,2-dioxaborolan-2-yl)phenyl)pyrimidine (CAS 1381862-91-4, 1 eq, 37.9 g), tetrakis(triphenylphosphine)palladium(o) (CAS 14221-01-3, 0.03 eq, 2.5 g), potassium carbonate (CAS 584-08-7, 2.5 eq 30.2 g). A deaerated mixture of 660 mL dioxane and 110 mL water was added. Reaction was running 2 days at 55°C under nitrogen atmosphere. A yellow suspension formed; the precipitate was filtered and washed with water, dioxane and 2-methoxy-2-methylpropane. The raw product was extracted in Soxhlet apparatus with toluene and dried, final purification was done by sublimation. Yield: 20.6 g (42 %)

### 2) 2-(3-(5-(5,5-dimethyl-5H-dibenzo[b,d]silol-3-yl)-3,6-diphenylpyrazin-2-yl)phenyl)-4,6-diphenylpyrimidine (E3)

A three-neck round-bottom flask was flushed with nitrogen and charged with 2-(3-(5-chloro-3,6-diphenylpyrazin-2-yl)phenyl)-4,6-diphenylpyrimidine (1 eq, 8.3 g), 5,5-dimethyl-3-(4,4,5,5-tetramethyl-1,3,2-dioxaborolan-2-yl)-5H-dibenzo[b,d]silole 28CAS 1262528-40-4, 1.8 eq, 9.4 g), chloro(crotyl)(2-dicyclohexylphosphino-2',6'-dimethoxybiphenyl)palladium(II) (CAS 1798781-99-3, 0.03 eq, 0.3 g), potassium phosphate (CAS 7778-53-2, 2 eq, 6.6 g). A deaerated mixture of 130 mL dioxane and 20 mL water was added. The reaction ran at reflux under a nitrogen atmosphere overnight; the reaction mixture was cooled down, the formed solid was filtered and washed with dioxane and methanol. The raw product was dissolved in 800 mL chloroform, the solution filtered through a silica pad and evaporated. The resulting solid was recrystallized from toluene; final purification was done by sublimation. White powder. Yield: 3.5 g (33 %), ESI-MS: 747 (M+H).

### 2-(3-(5-(5,5-dimethyl-5H-dibenzo[b,d]silol-i-yl)-3,6-diphenylpyrazin-2-yl)phenyl)-4,6-diphenylpyrimidine (E4)

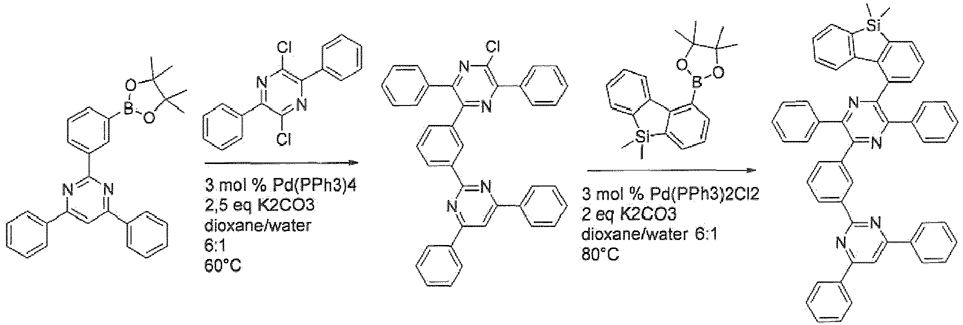

### 1) 2-(3-(5-chloro-3,6-diphenylpyrazin-2-yl)phenyl)-4,6-diphenylpyrimidine (I3)

See above

### 2) 2-(3-(5-(5,5-dimethyl-5H-dibenzo[b,d]silol-1-yl)-3,6-diphenylpyrazin-2-yl)phenyl)-4,6-diphenylpyrimidine (E4)

A three-neck round-bottom flask was flushed with nitrogen and charged with 2-(3-(5-chloro-3,6-diphenylpyrazin-2-yl)phenyl)-4,6-diphenylpyrimidine (1.00 eq, 15.0 g), 5,5-dimethyl-1-(4,4,5,5-tetramethyl-1,3,2-dioxaborolan-2-yl)-5H-dibenzo[b,d]silole (CAS 2359655-40-4, 1.1 eq, 9.7 g), bis(triphenylphosphine)-palladium-II-chloride (CAS 13965-03-2, 0.03 eq, 0.6 g), potassium carbonate 28CAS 584-08-7, 2.0 eq, 7.2 g). A deaerated mixture of 180 mL dioxane and 30 mL water was added. The reaction ran at 8o°C under nitrogen atmosphere overnight, the reaction mixture was cooled down, the precipitated solid was filtered and washed with water and hexane. The raw product was dissolved in 300 mL chloroform and the solution filtered through a silica pad. Then, the solvent was evaporated and the resulting solid was stirred in 120 mL mixture DCM/methanol (1:5 v/v). The obtained white solid precipitate was filtered and dried. Final purification was done by sublimation. White powder. Yield: 15.6 g (80 %).

### Supporting materials for device experiments

F1 is 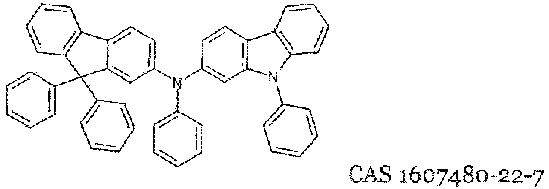
F2 is 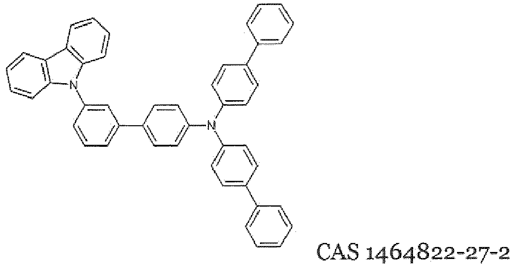
F3 is 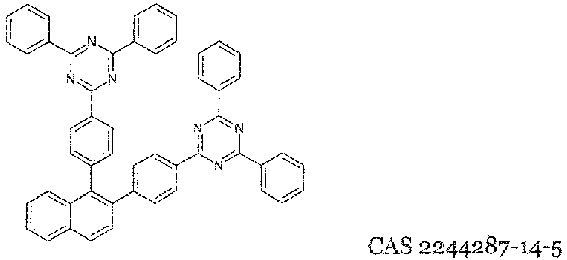
F4 is 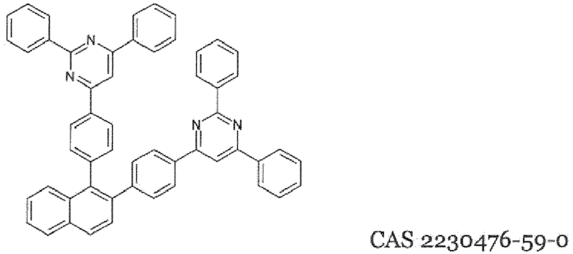
F5 is 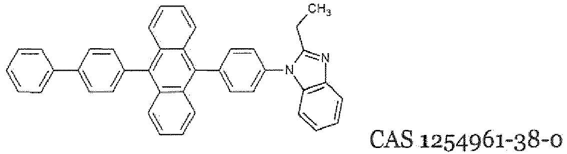
F6 is 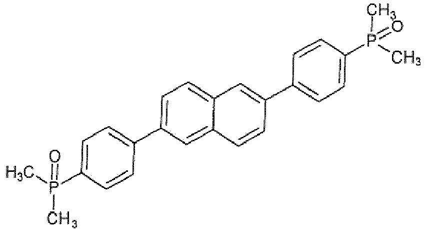 disclosed in WO2018/215348
F7 is 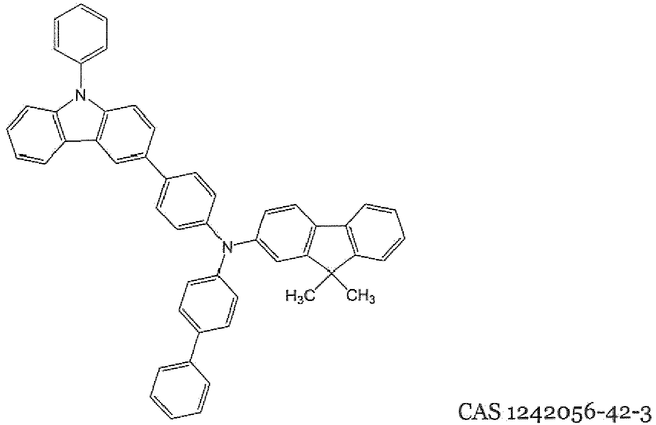
PD2 is 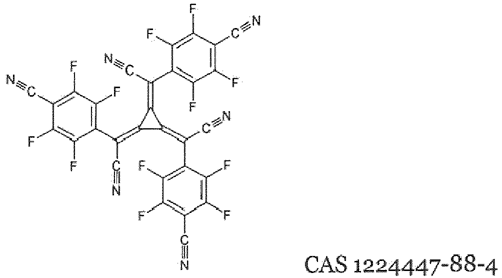
LiQ is lithium 8-hydroxyquinolinolate, CAS 850918-68-2
BH1 is 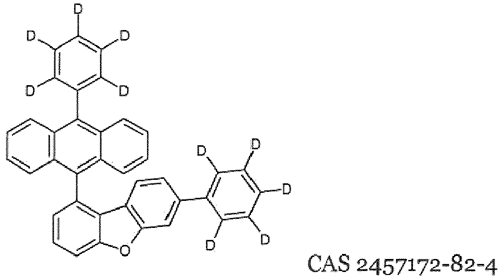
BD1 is

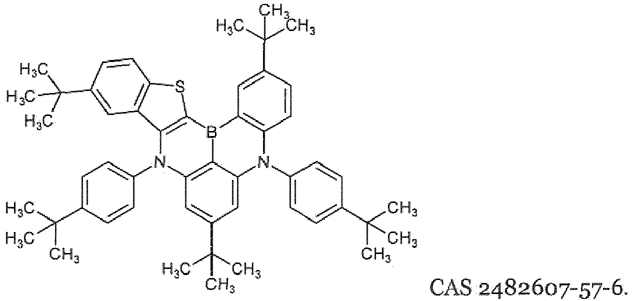

### Layer stack

For the following device experiments, blue fluorescent top emission OLEDs with layer stacks in accordance with Table 1 and Table 2 have been prepared.

**Table 1**

| Layer | Material | c [vol%] | d [nm] |
|---|---|---|---|
| anode | ITO/Ag/ITO | 100/100/100 | 10/120/10 |
| HIL | F1:PD-2 | 98:2 | 10 |
| HTL | F1 | 100 | 129 |
| EBL | F2 | 100 | 5 |
| EML | BH1:BD1 | 99:1 | 20 |
| HBL | Compound according to the invention (E1, E2, or E3) or comparative compound C1 | 100 | 5 |
| ETL | (F3 or F4):LiQ | 50:50 | 31 |
| EIL | Yb | 100 | 1.3 |
| cathode | Ag:Mg | 90:10 | 13 |
| capping layer | F7 | 100 | 75 |

**Table 2**

| Layer | Material | c [vol%] | d [nm] |
|---|---|---|---|
| anode | ITO/Ag/ITO | 100/100/100 | 10/120/10 |
| HIL | F1:PD-2 | 98:2 | 10 |
| HTL | F1 | 100 | 129 |
| EBL | F2 | 100 | 5 |
| EML | BH1:BD1 | 99:1 | 20 |
| HBL | Compound according to the invention (E1, E2, or E3) or comparative compound C1 | 100 | 5 |
| ETL | F5 or F6 | 100 | 30 |
| EIL1 | LiQ | 100 | 1 |
| EIL2 cathode | Yb Ag:Mg | 100 90:10 | 1.3 13 |
| capping layer | F7 | 100 | 75 |

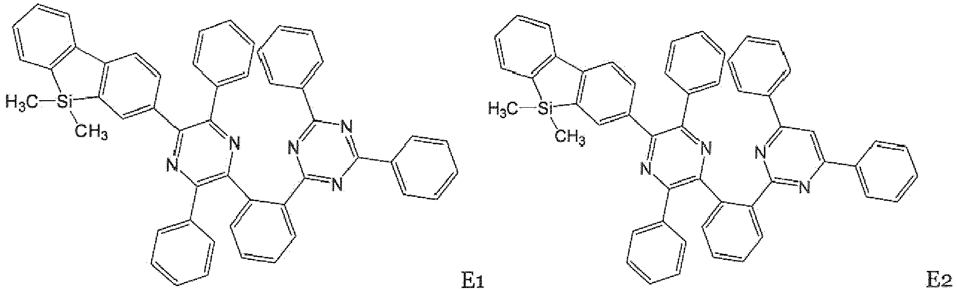

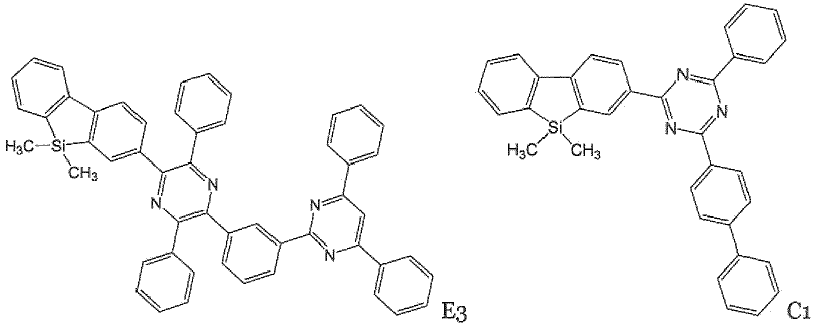

### Device experiments

**Table 3 (stack according to Table 1, F3 as ETL matrix)**

| HBL | CIE -y | U at 15 mA/cm² [V] | Rel. U % | CEFF/CIE-y at 15 mA/cm² [cd/A] | Rel. CEFF/CIE-y % |
|---|---|---|---|---|---|
| C1 | 0.058 | 3.80 | 100 | 176 | 100 |
| E1 | 0.057 | 3.62 | 95 | 197 | 112 |
| E2 | 0.057 | 3.84 | 101 | 190 | 108 |
| E3 | 0.057 | 3.52 | 93 | 207 | 118 |

In comparison with state-of-art compound C1, the inventive compounds enable lower operational voltage and/or higher current efficiency.

**Table 4 (stack according to Table 1, F4 as ETL matrix)**

| HBL | CIE-y | U at 15 mA/cm² [V] | Rel. U % | CEFF/CIE-y at 15 mA/cm² [cd/A] | Rel. CEFF/CIE-y % |
|---|---|---|---|---|---|
| C1 | 0.057 | 3.91 | 100 | 172 | 100 |
| E1 | 0.058 | 3.73 | 95 | 189 | 110 |
| E2 | 0.057 | 3.68 | 94 | 200 | 116 |
| E3 | 0.056 | 3.55 | 91 | 203 | 118 |

In comparison with state-of-art compound C1, the inventive compounds enable lower operational voltage and higher current efficiency.

**Table 5 (stack according to Table 2, F5 as ETL matrix)**

| HBL | CIE -y | U at 15 mA/cm² [V] | Rel. U % | CEFF/CIE-y at 15 mA/cm² [cd/A] | Rel. CEFF/CIE-y % |
|---|---|---|---|---|---|
| C1 | 0.061 | 3.80 | 100 | 163 | 100 |
| E1 | 0.061 | 3.61 | 95 | 179 | 110 |
| E2 | 0.061 | 3.69 | 97 | 182 | 112 |
| E3 | 0.060 | 3.47 | 95 | 192 | 118 |

In comparison with state-of-art compound C1, the inventive compounds enable lower operational voltage and higher current efficiency.

**Table 6 (stack according to Table 2, F6 as ETL matrix)**

| HBL | CIE -y | U at 15 mA/cm² [V] | Rel. U % | CEFF/CIE-y at 15 mA/cm² [cd/A] | Rel. CEFF/CIE-y % |
|---|---|---|---|---|---|
| C1 | 0.058 | 3.82 | 100 | 119 | 100 |
| E1 | 0.058 | 3.76 | 98 | 138 | 116 |
| E2 | 0.058 | 3.65 | 96 | 151 | 127 |

In comparison with state-of-art compound C1, the inventive compounds enable lower operational voltage and higher current efficiency.

The features disclosed in the foregoing description and in the dependent claims may, both separately and in any combination thereof, be material for realizing the aspects of the disclosure made in the independent claims, in diverse forms thereof.

## Claims

1. Compound comprising
- a structural moiety of the following formula (I) 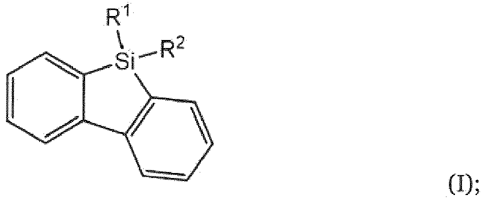 and
- a structural moiety of the following formula (II)
A-(Cy)ₙ-B (II)
wherein
- R¹ and R² are independently selected from the group consisting of substituted or unsubstituted C₁ to C₂₂ hydrocarbyl;
- A and B are independently selected from the group consisting of substituted or unsubstituted azine, substituted or unsubstituted diazine and substituted or unsubstituted triazine;
- Cy is a substituted or unsubstituted cyclic linker; and
- n is an integer from 1 to 3.

2. Compound according to claim 1 having the formula 1 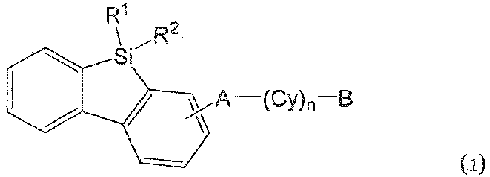 wherein
- R¹ and R² are independently selected from the group consisting of substituted or unsubstituted C₁ to C₂₂ hydrocarbyl;
- A and B are independently selected from the group consisting of substituted or unsubstituted azine, substituted or unsubstituted diazine and substituted or unsubstituted triazine;
Cy is a substituted or unsubstituted cyclic linker; and
n is an integer from 1 to 3.

3. Compound according to claim 1 or 2 having the formula 2 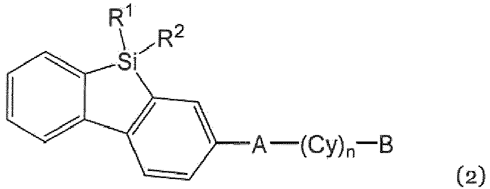 wherein
- R¹ and R² are independently selected from the group consisting of substituted or unsubstituted C₁ to C₂₂ hydrocarbyl;
- A and B are independently selected from the group consisting of substituted or unsubstituted azine, substituted or unsubstituted diazine and substituted or unsubstituted triazine;
Cy is a substituted or unsubstituted cyclic linker; and
n is an integer from 1 to 3.

4. Compound according to any of the preceding claims, wherein R¹ and R² are independently selected from the group consisting of substituted or unsubstituted C₁ to C₂₂ alkyl, substituted or unsubstituted C₃ to C₂₂ cycloalkyl; and substituted or unsubstituted C₆ to C₂₂ aryl.

5. Compound according to any of the preceding claims, wherein R¹ and R² are independently selected from the group consisting of substituted or unsubstituted C₁ to C₆ alkyl, substituted or unsubstituted C₃ to C₆ cycloalkyl and substituted or unsubstituted phenyl.

6. Compound according to any of the preceding claims, wherein the substituted or unsubstituted diazine is selected from the group consisting of substituted or unsubstituted pyrimidine and pyrazine.

7. Compound according to any of the preceding claims, wherein at least one of A and B is substituted or unsubstituted diazine.

8. Compound according to any of the preceding claims, wherein at least one of A and B is substituted pyrazine and the one or more substituent(s) are independently selected from the group consisting of a substituted or unsubstituted hydrocarbyl group, a substituted or unsubstituted carbocyclic group, and a substituted or unsubstituted heterocyclic group.

9. Compound according to any of the preceding claims, wherein at least one of A and B is substituted pyrazine and the one or more substituent(s) are independently selected from the group consisting of C₆ to C₁₈ aryl and C₃ to C₁₇ heteroaryl.

10. Compound according to any of the preceding claims, wherein Cy is selected form the group consisting of C₆ to C₁₈ arylene and C₃ to C₁₇ heteroarylene.

11. Compound according to any of the preceding claims, wherein Cy is monocyclic or bicyclic; preferably, Cy is substituted or unsubstituted phenylene or substituted or unsubstituted naphthalene-diyl.

12. Semiconducting material comprising the compound according to any of the preceding claims.

13. Organic electronic device comprising a first electrode, a second electrode and a layer comprising the semiconducting material according to claim 13 between the first electrode and the second electrode.

14. Display device comprising at least one organic electronic device according to claim 13.

15. Process for preparing the compound according to any of the claims 1 to 11, comprising:
reacting a first precursor compound comprising a structural moiety (Ia) 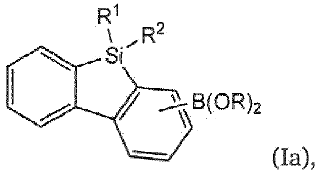 wherein
- R¹ and R² are independently selected from the group consisting of substituted or unsubstituted C₁ to C₂₂ hydrocarbyl; and
- R is independently H or a C₁ to C₂₂ hydrocarbyl, wherein the R may be connected with each other to form a ring,
with a second precursor compound having formula (IIa)
X-A-(Cy)ₙ-B (IIa)
wherein
- A and B are independently selected from the group consisting of substituted or unsubstituted azine, substituted or unsubstituted diazine and substituted or unsubstituted triazine;
- Cy is a substituted or unsubstituted cyclic linker; and
- n is an integer from 1 to 3.

16. Precursor compound for preparing a compound according to any of the claims 1 to 11, the precursor compound having the following formula (IIb) 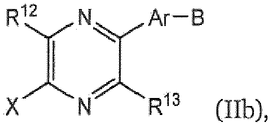 wherein
- R¹² and R¹³ are independently selected from an unsubstituted or substituted C₆ to C₁₈ aryl;
- Ar is selected from an unsubstituted or substituted C₆ to C₁₀ arylene,
- B is selected from the group consisting of substituted or unsubstituted azine, substituted or unsubstituted diazine and substituted or unsubstituted triazine; and
X is selected from F, Cl, Br and I.
